# EUROPEAN PATENT APPLICATION

(11) **EP 4 391 009 A1**
(43) Date of publication of application: **26.06.2024**
(21) Application number: 22215638.2
(22) Date of filing: 21.12.2022
(51) Int. Cl.: H01J 37/28, H01J 37/12

(54) **CHARGED PARTICLE DEVICE AND CHARGED PARTICLE APPARATUS**

(71) Applicant: ASML Netherlands B.V., 5500 AH Veldhoven (NL)
(72) Inventor: SMAKMAN, Erwin, Paul, 5500 AH Veldhoven (NL); VEENSTRA, Roy, Ramon, 5500 AH Veldhoven (NL); REN, Yan, 5500 AH Veldhoven (NL)
(74) Representative: ASML Netherlands B.V.

(57) **Abstract**

The present invention provides a charged particle device for projecting a multi-beam of charged particles towards a sample. The device comprises a plurality of sources configured to emit a respective source beam of charged particles along a respective path of a beam grid, comprising a plurality of charged particle beams, toward the sample. The device further comprises one or more elements in which an array of apertures is defined. The one or more elements respectively comprising a plurality of beam areas assigned to an individual source beam. The one or more elements is configured to operate on the charged particle beams in the beam grids of the individual source beam. Each element is separated from an adjoining element by a spacer, the spacer having at least one aperture positioned to correspond to the position of at least two beam areas.

## Description

### FIELD

The embodiments provided herein generally relate to charged particle device and charged particle apparatus comprising the charged particle device.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the assessment, e.g., inspection and/or measurement, of a surface of a substrate, or other object/material, is an important process during and/or after its manufacture.

Pattern assessment systems with a charged particle beam have been used to inspect objects, for example to detect pattern defects and to measure structural features on such objects. These tools typically use electron microscopy techniques, using electron optical systems for example in a scanning electron microscope (SEM). In exemplary electron optical system such a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over, or across, the sample surface, secondary electrons can be emitted across the surface of the sample. By collecting these emitted secondary electrons from the sample surface, a pattern assessment system (or assessment tool) may obtain an image representing characteristics of the material structure of the surface of the sample. The intensity of the electron beams comprising the backscattered electrons and the secondary electrons may vary based on the properties of the internal and external structures of the sample, and thereby may indicate whether the sample has defects.

There is a desire to increase the throughput of the assessment systems, such as for inspection, such that samples can be processed more quickly. In particular, there is a desire to increase throughput, for example to one wafer per hour. One technique to increase the throughput of assessment systems is to increase the number of charged particle devices, otherwise referred to as columns, positioned to scan each sample. However, there remains a problem that there is limited space in the assessment system, for example the assessment apparatus part of the assessment system such as the number of charged particle devices that may be accommodated in the assessment apparatus for scanning a sample of a typical size. Such an assessment system may be situated in production facility of a chip fabrication plant which may place a practical limit on the size, e.g. footprint, of the assessment. It is desirable that the footprint of a system in the production facility is as small as possible. The present invention therefore aims to increase throughput of samples for example addressing these constraints.

### SUMMARY

It is an object of the present disclosure to provide embodiments of a charged particle device and charged particle apparatus.

According to a first aspect of the invention, there is provided a charged particle device for projecting a multi-beam of charged particles towards a sample. The device comprises a plurality of sources configured to emit a respective source beam of charged particles along a respective path of a beam grid, comprising a plurality of charged particle beams, toward the sample. The device further comprises one or more elements in which an array of apertures is defined. The one or more elements respectively comprising a plurality of beam areas assigned to an individual source beam. The one or more elements is configured to operate on the charged particle beams in the beam grids of the individual source beam. Each element is separated from an adjoining element by a spacer, the spacer having at least one aperture positioned to correspond to the position of at least two beam areas.

According to a second aspect of the invention, there is provided charged particle apparatus for projecting a multi-beam of charged particles towards a sample, the apparatus comprising the device and a stage configured to support a sample.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary electron beam assessment apparatus.
**FIG. 2** is a schematic diagram illustrating an exemplary multi-beam charged particle assessment system that is part of the exemplary electron beam assessment apparatus of **FIG. 1****.**
**FIG. 3** is a schematic diagram of an exemplary multi-beam charged particle device.
**FIG. 4** is a schematic diagram of an exemplary electron-optical system comprising a macro collimator and macro scan deflector.
**FIG. 5** is a schematic diagram of an exemplary charged particle device comprising a collimator element array and a scan-deflector array.
**FIG. 6** is a schematic diagram of an exemplary multi-beam charged particle device.
**FIG.** 7 is a schematic diagram providing plan view of an element of a charged particle device, including a single beam area associated with a beam grid.
**FIG. 8** is a schematic diagram of a charged particle device comprising a plurality of sub-devices each comprising a charged particle beam source.
**FIG. 9A-C** are schematic diagrams providing plan view of an element of a charged particle device, including a plurality of beam areas, each associated with a different beam grid.
**FIG. 10** is a schematic diagram providing plan view of an element of a charged particle device, including a plurality of beam areas arranged in a plurality of rings around a mid-region.
**FIG. 11** is a schematic diagram of a charged particle apparatus including a charged particle device having beam area arrangement as shown in **FIG. 9B****.**

The schematic diagrams and views show the components described below. However, the components depicted in the figures are not to scale.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus semiconductor IC manufacturing is a complex and time-consuming process, with many individual steps. An error in one of these steps has the potential to significantly influence the functioning of the final product. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by assessment systems (such as, or such as comprising, a Scanning Electron Microscope (`SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. Such an assessment apparatus may utilize a single primary electron beam incident on a sample. For high throughput inspection, some of the assessment apparatuses use multiple focused beams, i.e. a multi-beam, of primary electrons. The component beams of the multi-beam may be referred to as sub-beams or beamlets. The sub-beams may be arranged with respect to each other within the multi-beam in a multi-beam arrangement. A multi-beam can scan different parts of a sample simultaneously. A multi-beam assessment apparatus can therefore assess, for example inspect, a sample at a much higher speed than a single-beam assessment apparatus.

An implementation of known multi-beam assessment apparatus and systems is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical system, it is appreciated that the embodiments are not used to limit the present disclosure to specific charged particles. References to electrons throughout the present document may therefore be more generally be considered to be references to charged particles, with the charged particles not necessarily being electrons.

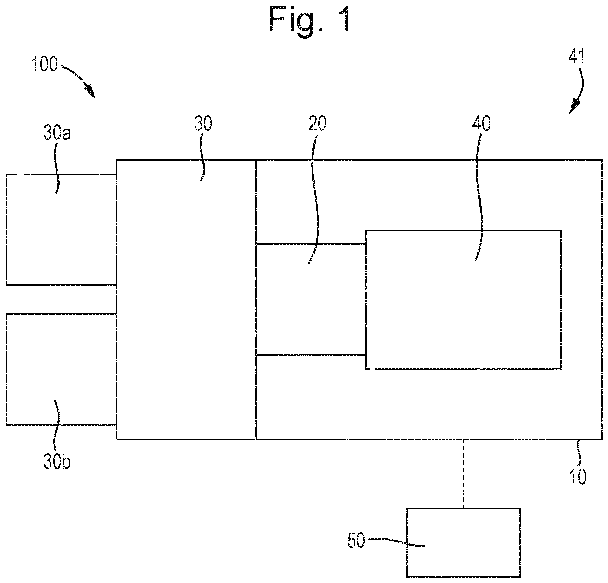

Reference is now made to **FIG. 1****,** which is a schematic diagram illustrating an exemplary charged particle beam assessment apparatus 100. It should be noted that the assessment apparatus comprises part of the assessment system, often the part of the assessment system situated in a fabrication facility. The assessment apparatus may cover a surface area of the fabrication facility floor referred to as an apparatus footprint. The other parts of the assessment system such as service systems of vacuum and fluid supplies and remote processing racks may be located elsewhere in the fabrication facility away from other fabrication systems and apparatus where space is a less significant requirement,

The charged particle beam assessment apparatus 100 of **FIG. 1** includes a main chamber 10, a load lock chamber 20, a charged particle assessment system 40 (which may also be called an electron beam system or tool), an equipment front end module (EFEM) 30 and a controller 50. The charged particle assessment system 40 is located within the main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be assessed e.g. measured or inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the charged particle assessment system 40 by which it may be assessed. The charged particle assessment system 40 comprises a charged particle device 41. The charged particle device 41 may be an electron-optical device, which may be synonymous with the electron-optical system. The charged particle device 41 may be a multi-beam charged particle device 41 configured to project a multi-beam towards the sample, for example the sub-beams being arranged with respect to each other in a multi-beam arrangement. Alternatively, the charged particle device 41 may be a single beam charged particle device 41 configured to project a single beam towards the sample.

The controller 50 is electronically connected to the charged particle assessment system 40. The controller 50 may be a processor (such as a computer) configured to control the charged particle beam assessment apparatus 100. The controller 50 may also include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the charged particle beam assessment apparatus or it can be distributed over at least two of the component elements. While the present disclosure provides examples of the main chamber 10 housing an electron beam assessment apparatus, it should be noted that aspects of the disclosure in their broadest sense are not limited to a chamber housing an electron beam assessment apparatus. Rather, it is appreciated that the foregoing principles may also be applied to other tools and other arrangements of apparatus, that operate under the second pressure.

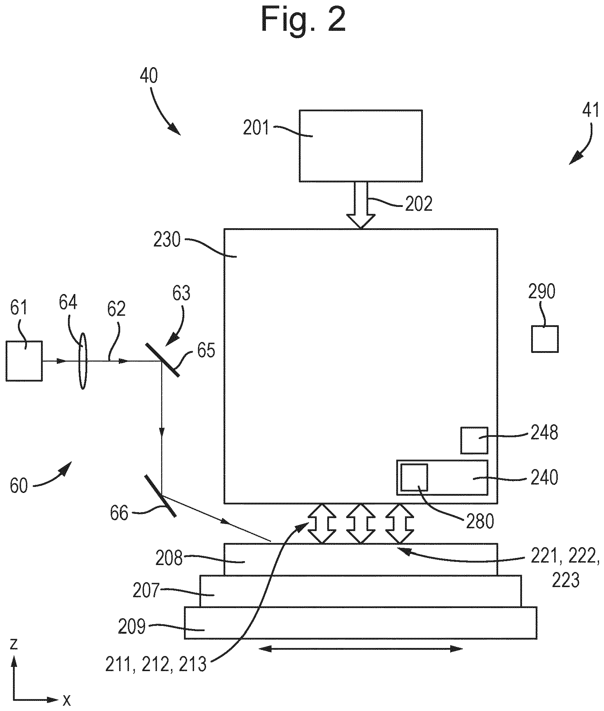

Reference is now made to **FIG. 2****,** which is a schematic diagram illustrating an exemplary charged particle assessment system 40 including a multi-beam charged particle device 41 that is part of the exemplary charged particle beam assessment apparatus 100 of **FIG. 1****.** The multi-beam charged particle device 41 comprises an electron source 201 and a projection apparatus 230. The charged particle assessment system 40 further comprises an actuated stage 209 and a sample holder 207. The sample holder may have a holding surface (not depicted) for supporting and holding the sample. Thus the sample holder may be configured to support the sample. Such a holding surface may be a electrostatic clamp operable to hold the sample during operation of the charged particle device 41 e.g. assessment such as measurement or inspection of at least part of the sample. The holding surface may be recessed into sample holder, for example a surface of the sample holder orientated to face the charged particle device 41. The electron source 201 and projection apparatus 230 may together be referred to as the charged particle device 41. The sample holder 207 is supported by actuated stage 209 so as to hold a sample 208 (e.g., a substrate or a mask) for assessment. The multi-beam charged particle device 41 further comprises a detector 240 (e.g. an electron detection device).

The electron source 201 may comprise a cathode (not shown) and an extractor or anode (not shown). During operation, the electron source 201 is configured to emit electrons as primary electrons from the cathode. The primary electrons are extracted or accelerated by the extractor and/or the anode to form a primary electron beam 202.

The projection apparatus 230 is configured to convert the primary electron beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets.

The controller 50 may be connected to various parts of the charged particle beam assessment apparatus 100 of **FIG. 1****,** such as the electron source 201, the detector 240, the projection apparatus 230, and the actuated stage 209. The controller 50 may perform various image and signal processing functions. The controller 50 may also generate various control signals to govern operations of the charged particle beam assessment apparatus, including the charged particle multi-beam apparatus.

The projection apparatus 230 may be configured to focus sub-beams 211, 212, and 213 onto a sample 208 for assessment and may form three probe spots 221, 222, and 223 on the surface of sample 208. The projection apparatus 230 may be configured to deflect the primary sub-beams 211, 212, and 213 to scan the probe spots 221, 222, and 223 across individual scanning areas in a section of the surface of the sample 208. In response to incidence of the primary sub-beams 211, 212, and 213 on the probe spots 221, 222, and 223 on the sample 208, electrons are generated from the sample 208 which include secondary electrons and backscattered electrons. The secondary electrons typically have electron energy < 50 eV. Actual secondary electrons can have an energy of less than 5 eV, but anything beneath 50 eV is generally treated at a secondary electron. Backscattered electrons typically have electron energy between 0 eV and the landing energy of the primary sub-beams 211, 212, and 213. As electrons detected with an energy of less than 50 eV is generally treated as a secondary electron, a proportion of the actual backscatter electrons will be counted as secondary electrons.

The detector 240 is configured to detect signal particles such as secondary electrons and/or backscattered electrons and to generate corresponding signals which are sent to a signal processing system 280, e.g. to construct images of the corresponding scanned areas of sample 208. The detector 240 may be incorporated into the projection apparatus 230.

The signal processing system 280 may comprise a circuit (not shown) configured to process signals from the detector 240 so as to form an image. The signal processing system 280 could otherwise be referred to as an image processing system. The signal processing system may be incorporated into a component of the multi-beam charged particle assessment system 40 such as the detector 240 (as shown in **FIG. 2**). However, the signal processing system 280 may be incorporated into any components of the assessment apparatus 100 or multi-beam charged particle assessment system 40, such as, as part of the projection apparatus 230 or the controller 50. The signal processing system 280 may include an image acquirer (not shown) and a storage device (not shown). For example, the signal processing system may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive a signal from the detector 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The signal processing system 280 may include measurement circuitry (e.g., analog-to-digital converters) to obtain a distribution of the detected secondary electrons. The electron distribution data, collected during a detection time window, can be used in combination with corresponding scan path data of each of primary sub-beams 211, 212, and 213 incident on the sample surface, to reconstruct images of the sample structures under assessment. The reconstructed images can be used to reveal various features of the internal or external structures of the sample 208. The reconstructed images can thereby be used to reveal any defects that may exist in the sample.

The controller 50 may control the actuated stage 209 to move sample 208 during assessment, e.g. inspection, of the sample 208. The controller 50 may enable the actuated stage 209 to move the sample 208 in a direction, preferably continuously, for example at a constant speed, at least during sample assessment. The controller 50 may control movement of the actuated stage 209 so that it changes the speed of the movement of the sample 208 dependent on various parameters. For example, the controller 50 may control the stage speed (including its direction) depending on the characteristics of the assessment steps of scanning process.

Known multi-beam systems, such as the charged particle assessment system 40 and charged particle beam assessment apparatus 100 described above, are disclosed in US2020118784, US20200203116, US 2019/0259570 and US2019/0259564 which are hereby incorporated by reference.

As shown in **FIG. 2****,** in an embodiment the charged particle assessment system 40 has a single charged particle device 41 and optionally comprises a projection assembly 60. The projection assembly 60 may be a module and may be referred to as an ACC module. The projection assembly 60 is arranged to direct a light beam 62 such that the light beam 62 enters between the charged particle device 41 and the sample 208.

When the electron beam scans the sample 208, charges may be accumulated on the sample 208 due to large beam current, which may affect the quality of the image. To regulate the accumulated charges on the sample, the projection assembly 60 may be employed to illuminate the light beam 62 on the sample 208, so as to control the accumulated charges due to effects such as photoconductivity, photoelectric, or thermal effects.

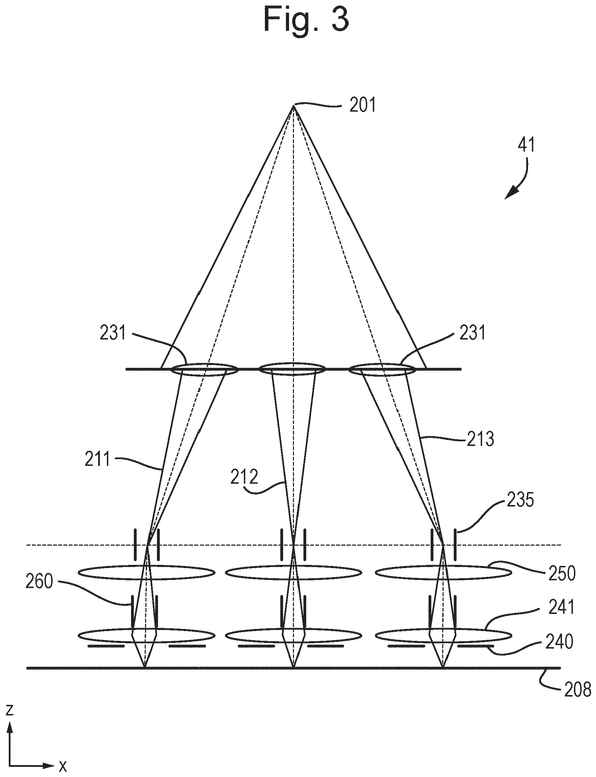

Components of a charged particle assessment system 40 which may be used in the present invention are described below in relation to **FIG. 3** which is a schematic diagram of a charged particle assessment system 40. The charged particle assessment system 40 of **FIG. 3** may correspond to the charged particle assessment system 40 (which may also be referred to as an apparatus or a tool) mentioned above.

The electron source 201 directs electrons toward an array of condenser lenses 231 (otherwise referred to as a condenser lens array). The electron source 201 is desirably a high brightness emitter arranged to operate within an optimized electron-optical performance range that is a compromise between brightness and total emission current (such a compromise may be considered to be a 'good' compromise'). The electron source emits a source beam. There may be many tens, many hundreds or many thousands, or even tens of thousands of condenser lenses 231. The condenser lenses 231 may comprise multi-electrode lenses and have a construction based on EP1602121A1, which document is hereby incorporated by reference in particular to the disclosure of a lens array to split a source beam into a plurality of sub-beams. An most up beam plate, which may be referred to as beam limiting aperture array, and which may be the most up beam plate of the condenser lens array, may generate the plurality of beams. The array condenser lenses (which may comprise the beam limiting aperture array) may provide a lens for each sub-beam. The array of condenser lenses 231 may take the form of at least two plates, acting as electrodes, with an aperture in each plate aligned with each other and corresponding to the location of a sub-beam. At least two of the plates are maintained during operation at different potentials to achieve the desired lensing effect.

In an arrangement the array of condenser lenses 231 is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

Each condenser lens 231 in the array directs electrons into a respective sub-beam 211, 212, 213 which is focused at a respective intermediate focus downbeam of the condenser lens array. The sub-beams diverge with respect to each other. In an embodiment, deflectors 235 are provided at the intermediate focuses. The deflectors 235 are positioned in the sub-beam paths at, or at least around, the position of the corresponding intermediate points of focus. The deflectors 235 are positioned in or close to the sub-beam paths at the intermediate image plane of the associated sub-beam. The deflectors 235 are configured to operate on the respective sub-beams 211, 212, 213. The deflectors 235 are configured to bend a respective sub-beam 211, 212, 213 by an amount effective to ensure that the principal ray (which may also be referred to as the beam axis) is incident on the sample 208 substantially normally (i.e. at substantially 90° to the nominal surface of the sample). The deflectors 235 may also be referred to as collimators or collimator deflectors. The deflectors 235 in effect collimate the paths of the sub-beams so that before the deflectors, the sub-beam paths with respect to each other are diverging. Downbeam of the deflectors the sub-beam paths are substantially parallel with respect to each other, i.e. substantially collimated. Suitable collimators are deflectors disclosed in EP Application 20156253.5 filed on 7 February 2020 which is hereby incorporated by reference with respect to the application of the deflectors to a multi-beam array. In an embodiment of the arrangement, the collimator may comprise a macro collimator, instead of, or in addition to the deflectors 235. The macro-collimator may be electrostatic for example as two more planar plates with a single aperture.

Below (i.e. downbeam or further from source 201) the deflectors 235 there is a control lens array 250. The sub-beams 211, 212, 213 having passed through the deflectors 235 are substantially parallel on entry to the control lens array 250. The control lenses pre-focus the sub-beams (e.g. apply a focusing action to the sub-beams prior to the sub-beams reaching an objective lens array 241). The pre-focusing may reduce divergence of the sub-beams or increase a rate of convergence of the sub-beams. The control lens array 250 and the objective lens array 241 operate together to provide a combined focal length. Combined operation without an intermediate focus may reduce the risk of aberrations. In an embodiment the control lenses of the control lens array may be considered to be part of the objective lenses of the objective lens array. The electrode plates of the control lens array may be considered electron-optically to be additional electrode plates of the objective lens array.

It is desirable to use the control lens array 250 to determine the landing energy. However, it is possible to use in addition the objective lens array 241 to control the landing energy. In such a case, a potential difference over the objective lens is changed when a different landing energy is selected. One example of a situation where it is desirable to partly change the landing energy by changing the potential difference over the objective lens is to prevent the focus of the sub-beams getting too close to the objective lenses. In such a situation there is a risk of components of the objective lens array 241 having to be too thin to be manufacturable. The same may be said about a detector at this location. This situation can for example occur in case the landing energy is lowered. This is because the focal length of the objective lens roughly scales with the landing energy used. By lowering the potential difference over the objective lens, and thereby lowering the electric field inside the objective lens, the focal length of the objective lens is made larger again, resulting in a focus position further below the objective lens. Note that use of just an objective lens would limit control of magnification. Such an arrangement could not control demagnification and/or opening angle. Further, using the objective lens to control the landing energy could mean that the objective lens would be operating away from its optimal field strength. That is unless mechanical parameters of the objective lens (such as the spacing between its electrodes) could be adjusted, for example by exchanging the objective lens.

The control lens array 250 comprises a plurality of control lenses. Each control lens comprises at least two electrodes (e.g. two or three electrodes) connected to respective potential sources. The control lens array 250 may comprise two or more (e.g. three) plate electrode arrays connected to respective potential sources. The control lens array 250 is associated with the objective lens array 241 (e.g. the two arrays are positioned close to each other and/or mechanically connected to each other and/or controlled together as a unit). Each control lens may be associated with a respective objective lens. The control lens array 250 is positioned upbeam of the objective lens array 241.

The control lens array 250 comprises a control lens for each sub-beam 211, 212, 213. A function of the control lens array 250 is to optimize the beam opening angle with respect to the demagnification of the beam and/or to control the beam energy delivered to the objective lens array 241 which directs the sub-beams 211, 212, 213 onto the sample 208. The objective lens array 241 may be positioned at or near the base of the charged particle device 41. The control lens array 250 is optional, but is preferred for optimizing a sub-beam upbeam of the objective lens array. In an arrangement the control lens array 250 may be considered to be part of the objective lens array. The plates of the control lens array may be considered to be additional plates of the objective lens array. Within an objective lens array meeting this definition the function of the control lens array may be a function of the objective lens array in addition to the functions of the objective lens array herein described.

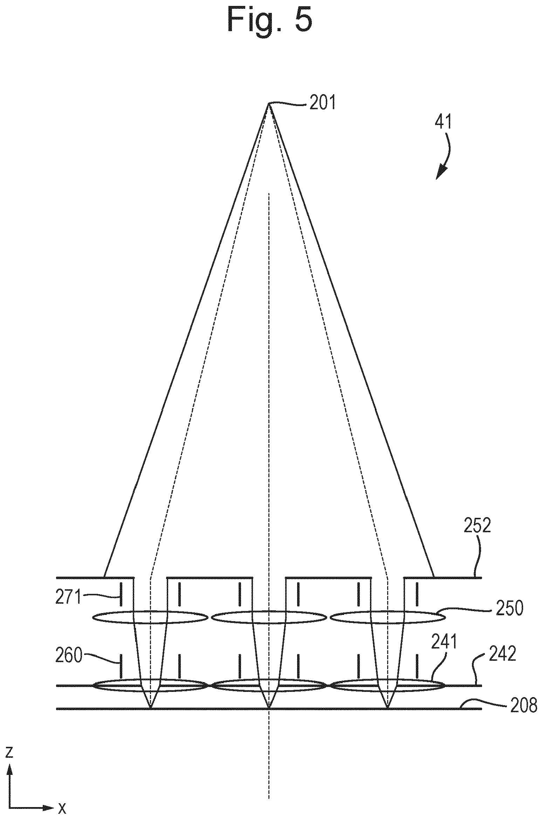

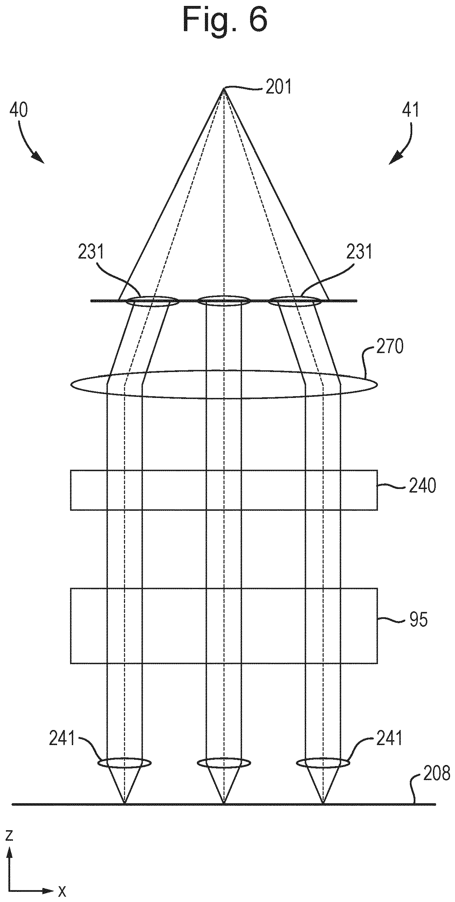

For ease of illustration, lens arrays are depicted schematically herein by arrays of oval shapes (as shown in **FIG. 3** and for that matter **FIGs 5** **and** **6**). Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. Lens arrays may instead comprise multiple plates with apertures.

An array of scan deflectors 260 may be provided between the control lens array 250 and the array of objective lenses 234. The array of scan deflectors 260 comprises a scan deflector for each sub-beam 211, 212, 213. Each scan deflector is configured to deflect a respective sub-beam 211, 212, 213 in one or two directions so as to scan the sub beam across the sample 208 in one or two directions.

The schematic diagram of an exemplary charged particle device, as shown in **FIG. 3** has an objective lens array assembly. The objective lens array assembly comprises the objective lens array 241. The objective lens array 241 comprises a plurality of objective lenses. Each objective lens comprises at least two electrodes (e.g. two or three electrodes) connected to respective potential sources. The objective lens array 241 may comprise two or more (e.g. three) plate electrode arrays connected to respective potential sources. Each objective lens formed by the plate electrode arrays may be a micro-lens operating on a different sub-beam or group of sub-beams in the multi-beam. Each plate defines a plurality of apertures (which may also be referred to as holes). The position of each aperture in a plate corresponds to the position of a corresponding aperture (or corresponding hole) in the other plate (or plates). The corresponding apertures define the objective lenses and each set of corresponding holes therefore operates in use on the same sub-beam or group of sub-beams in the multi-beam. Each objective lens projects a respective sub-beam of the multi-beam onto a sample 208.

The objective lens array assembly further comprises the control lens array 250. The control lens array 250 comprises a plurality of control lenses. Each control lens comprises at least two electrodes (e.g. two or three electrodes) connected to respective potential sources. The control lens array 250 may comprise two or more (e.g. three) plate electrode arrays connected to respective potential sources. The control lens array 250 is associated with the objective lens array 241 (e.g. the two arrays are positioned close to each other and/or mechanically connected to each other and/or controlled together as a unit). The control lens array 250 is positioned up-beam of the objective lens array 241. The control lenses pre-focus the sub-beams. (e.g. apply a focusing action to the sub-beams prior to the sub-beams reaching the objective lens array 241). The pre-focusing may reduce divergence of the sub-beams or increase a rate of convergence of the sub-beams. The control lens array and the objective lens array operate together to provide a combined focal length. Combined operation without an intermediate focus may reduce the risk of aberrations. In an embodiment, the control lens array may be considered to be part of the objective lens array.

In the arrangement of **FIG. 3****,** the objective lens array assembly comprises the scan-deflector array 260. The scan-deflector array 260 comprises a plurality of scan deflectors. The scan-deflector array 260 may be formed using MEMS manufacturing techniques. Each scan deflector scans a respective sub-beam over, or across, the sample 208. The scan-deflector array 260 may thus comprise a scan deflector for each sub-beam. Each scan deflector may deflect rays in the sub-beam in one direction (e.g. parallel to a single axis, such as an X axis) or in two directions (e.g. relative to two non-parallel axes, such as X and Y axes). The deflection is such as to cause the sub-beam to be scanned across the sample 208 in the one or two directions (i.e. one dimensionally or two dimensionally). In an embodiment, the scanning deflectors described in EP2425444, which document is hereby incorporated by reference in its entirety specifically in relation to scan deflectors, may be used to implement the scan-deflector array 260. The scan-deflector array 260 is positioned between the objective lens array 241 and the control lens array 250. In the embodiment shown, the scan-deflector array 260 is provided instead of a macro scan deflector, such as an electrostatic scan deflector (not shown). A scan-deflector array 260 may be more spatially compact than a macro scan deflector.

The objective lens array assembly may comprise a detector 240. (Alternatively the detector maybe comprised in the charged particle device 41 without having to be present in the objective lens array assembly). The detector 240 may comprise detector elements (e.g. sensor elements such as capture electrodes). The detector 240 may comprise any appropriate type of detector. For example, the detector elements may be charged based detector configured to detect charge detected with respect to time e.g. as current, scintillators or using semiconductor devices such as PIN elements. The detector 240 may be a direct current detector or an indirect current detector.

The detector 240 may be positioned between the objective lens array 241 and the sample 208. The detector 240 is configured to be the most down-beam feature of the electron-optical device, for example proximate the sample 208. The detector 240 may be very close to the sample 208, for example less than 5mm, 3mm, 1.5 mm, 300 µm, preferably between 200 and 10 µm, more preferably between 100 and 30 µm, for example between 40 and 70 µm.

The detector 240 may be positioned in the device so as to face the sample 208. Alternatively or additionally, the detector 240 may be positioned elsewhere in the electron-optical system 41 such that part of the electron-optical device that faces the sample 208 is other than, and thus is not, a detector; such as an electrode of the objective lens arrangement In such an arrangement another element of the electron-optical device may face the sample during operation, for example an electrode plate of the objective lens. In all these arrangements there is a most downbeam element of the electron-optical system, such as detector 240, most proximate to the sample. The most downbeam surface of the most downbeam element may face the sample. The most downbeam surface may be referred to as a facing surface.

A bottom surface of the detector 240 (or a facing surface of the detector 240 which may face a sample 208 in use, may comprise a substrate on which are provided a plurality of detector elements. Each detector element may surround a beam aperture. The beam apertures may be formed by etching through the substrate. In the arrangement the beam apertures are in a hexagonal close packed array, or alternatively in a rectangular array. The detector elements may be arranged in a rectangular array or a hexagonal array.

In cross section of the detector, the detector elements form the bottommost, i.e. most close to the sample 208, surface of the detector 240. Between the detector elements and the main body of the substrate a logic layer may be provided. At least part of the signal processing system may be incorporated into the logic layer. A wiring layer is provided on the backside of, or within, the substrate and connected to the logic layer by through-substrate vias. The wiring layer can include control lines, data lines and power lines. A printed circuit board and/or other semiconductor chips may be provided on, for example connected to, the backside of detector 240.

The detector 240 may be implemented by integrating a CMOS chip detector into an electrode of the objective lens array 241, such as the bottom electrode of the objective lens array 241. Integration of a detector 240 into the objective lens array 241 or other component of the electron-optical system 41 allows for the detection of electrons emitted in relation to multiple respective sub-beams. The CMOS chip may embody the detector it may be orientated to face the sample. In an embodiment, detector elements to capture the secondary charged particles are formed in the surface metal layer of the CMOS device. The detector elements can be formed in other layers. Power and control signals of the CMOS may be connected to the CMOS by the through-silicon vias. A passive silicon substrate with holes shields the CMOS chip from high E-fields, for example providing robustness.

In order to maximize the detection efficiency it is desirable to make the surface of the detector elements as large as possible, so that substantially all the area of the objective lens array 240 (excepting the apertures) is occupied by detector elements. Additionally or alternatively, each detector element has a diameter substantially equal to an array pitch (i.e. of the pitch of the apertures of the aperture array in the electrodes of the objective lens assembly 241). The diameter of each detector element may be less than approximately 600 µm, and preferably between approximately 50 µm and 500 µm. The pitch may be selected depending on the intended distance between the sample 208 and the detector 240. In an embodiment the outer shape of the detector element is a circle, but this can be made a square to maximize the detection area. The diameter of the through-substrate via can be minimized. A typical size of the electron beam is in the order of 5 to 15 µm.

In an embodiment, a single detector element surrounds each beam aperture. In another embodiment, a plurality of detector elements are provided around each beam aperture.

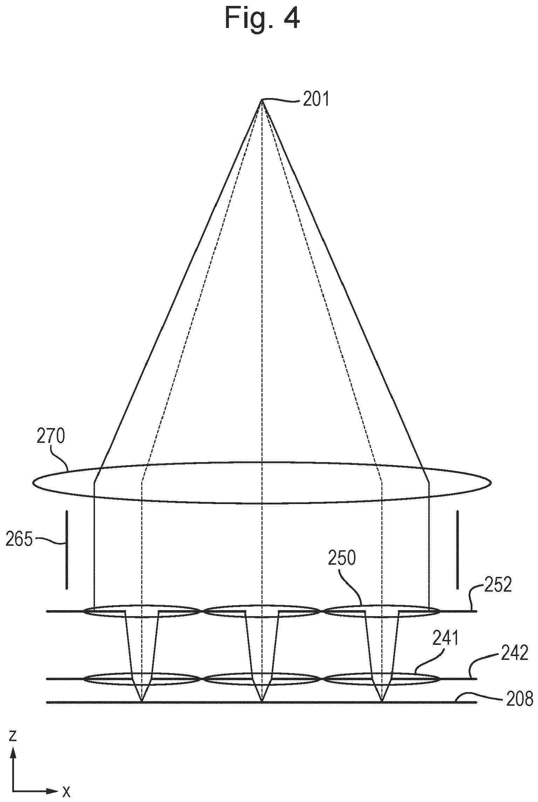

**FIG. 4** is a schematic diagram of an exemplary electron-optical system having the objective lens array assembly. The objective lens array assembly comprises an objective lens array 241. The objective lens array 241 comprises a plurality of objective lenses. Each objective lens comprises at least two electrodes (e.g. two or three electrodes) connected to respective potential sources. The objective lens array 241 may comprise two or more (e.g. three) plate electrode arrays connected to respective potential sources. Each objective lens formed by the plate electrode arrays may be a micro-lens operating on a different sub-beam or group of sub-beams in the multi-beam. Each plate defines a plurality of apertures (which may also be referred to as holes). The position of each aperture in a plate corresponds to the position of a corresponding aperture (or corresponding hole) in the other plate (or plates). The corresponding apertures define the objective lenses and each set of corresponding holes therefore operates in use on the same sub-beam or group of sub-beams in the multi-beam. Each objective lens projects a respective sub-beam of the multi-beam onto a sample 208.

For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. As described above, lens arrays may instead comprise multiple plates with apertures.

The objective lens array assembly further comprises a control lens array 250. The control lens array 250 comprises a plurality of control lenses. Each control lens comprises at least two electrodes (e.g. two or three electrodes) connected to respective potential sources. The control lens array 250 may comprise two or more (e.g. three) plate electrode arrays connected to respective potential sources. The control lens array 250 is associated with the objective lens array 241 (e.g. the two arrays are positioned close to each other and/or mechanically connected to each other and/or controlled together as a unit). The control lens array 250 is positioned up-beam of the objective lens array 241. The control lenses pre-focus the sub-beams (e.g. apply a focusing action to the sub-beams prior to the sub-beams reaching the objective lens array 241). The pre-focusing may reduce divergence of the sub-beams or increase a rate of convergence of the sub-beams. The control lens array and the objective lens array operate together to provide a combined focal length. Combined operation without an intermediate focus may reduce the risk of aberrations.

In an embodiment, an electron-optical system comprising the objective lens array assembly is configured to control the objective lens assembly (e.g. by controlling potentials applied to electrodes of the control lens array 250) so that a focal length of the control lenses is larger than a separation between the control lens array 250 and the objective lens array 241. The control lens array 250 and objective lens array 241 may thus be positioned relatively close together, with a focusing action from the control lens array 250 that is too weak to form an intermediate focus between the control lens array 250 and objective lens array 241. In other embodiments, the objective lens array assembly may be configured to form an intermediate focus between the control lens array 250 and the objective lens array 241.

In an embodiment, the control lens array is an exchangeable module, either on its own or in combination with other elements such as the objective lens array and/or detector array. The exchangeable module may be field replaceable, i.e. the module can be swapped for a new module by a field engineer. In an embodiment, multiple exchangeable modules are contained within the tool and can be swapped between operable and non-operable positions without opening the tool.

In an embodiment the exchangeable module comprises an electron-optical component which is on a stage permitting actuation for positioning of the component. In an embodiment the exchangeable module comprises a stage. In an arrangement the stage and the exchangeable module may be an integral part of the charged particle device 41. In an arrangement the exchangeable module is limited to the stage and the electron-optical device it supports. In an arrangement the stage is removable. In an alternative design the exchangeable module comprising the stage is removable. The part of the electron-optical tool 40 for the exchangeable module is isolatable, that is the part of the charged particle system 40 is defined by a valve up-beam and a valve down-beam of the exchangeable module. The valves can be operated to isolate the environment between the valves from the vacuum up-beam and down-beam of the valves respectively enabling the exchangeable module to be removed from the charged particle system 40 whilst maintaining the vacuum up-beam and down-beam of the part of the column associated with the exchangeable module. In an embodiment the exchangeable module comprises a stage. The stage is configured to support an electron-optical device relative to the beam path. In an embodiment the module comprises one or more actuators. The actuators are associated with the stage. The actuators are configured to move the electron-optical device relative to the beam path. Such actuation may be used to align the electron-optical device and the beam path with respect to each other.

In an embodiment, the exchangeable module is a MEMS module. In an embodiment, the exchangeable module is configured to be replaceable within the charged particle device 41. In an embodiment, the exchangeable module is configured to be field replaceable. Field replaceable is intended to mean that the module may be removed and replaced with the same or different module while maintaining the vacuum in which the charged particle device 41 is located. Only a section of the column is vented corresponding to the module is vented for the module to be removed and returned or replaced.

The control lens array may be in the same module as an objective lens array 241, i.e. forming an objective lens array assembly or objective lens arrangement, or it may be in a separate module

An electric power source may be provided to apply respective potentials to electrodes of the control lenses of the control lens array 250 and the objective lenses of the objective lens array 241.

The provision of a control lens array 250 in addition to an objective lens array 241 provides additional degrees of freedom for controlling properties of the sub-beams. The additional freedom is provided even when the control lens array 250 and objective lens array 241 are provided relatively close together, for example such that no intermediate focus is formed between the control lens array 250 and the objective lens array 241. The control lens array 250 may be used to optimize a beam opening angle with respect to the demagnification of the beam and/or to control the beam energy delivered to the objective lens array 241. The control lens may comprise 2 or 3 or more electrodes. If there are two electrodes then the demagnification and landing energy are controlled together. If there are three or more electrodes the demagnification and landing energy can be controlled independently. The control lenses may thus be configured to adjust the demagnification and/or beam opening angle of respective sub-beams (e.g. using the electric power source to apply suitable respective potentials to the electrodes of the control lenses and the objective lenses). This optimization can be achieved without having an excessively negative impact on the number of objective lenses and without excessively deteriorating aberrations of the objective lenses (e.g. without increasing the strength of the objective lenses).

In the embodiment of **FIG. 4****,** the electron-optical system comprises a source 201. The source 201 provides a beam of charged particles (e.g. electrons). The multi-beam focused on the sample 208 is derived from the beam provided by the source 201. Sub-beams may be derived from the beam, for example, using a beam limiter defining an array of beam-limiting apertures. The source 201 is desirably a high brightness thermal field emitter with a good compromise between brightness and total emission current. In the example shown, a collimator is provided up-beam of the objective lens array assembly. The collimator may comprise a macro collimator 270. The macro collimator 270 acts on the beam from the source 201 before the beam has been split into a multi-beam. The macro collimator 270 bends respective portions of the beam by an amount effective to ensure that a beam axis of each of the sub-beams derived from the beam is incident on the sample 208 substantially normally (i.e. at substantially 90° to the nominal surface of the sample 208). The macro collimator 270 applies a macroscopic collimation to the beam. The macro collimator 270 may thus act on all of the beam rather than comprising an array of collimator elements that are each configured to act on a different individual portion of the beam. The macro collimator 270 may comprise a magnetic lens or magnetic lens arrangement comprising a plurality of magnetic lens sub-units (e.g. a plurality of electromagnets forming a multi-pole arrangement). Alternatively or additionally, the macro-collimator may be at least partially implemented electrostatically, for example wholly electrostatically. The macro-collimator may comprise an electrostatic lens or electrostatic lens arrangement comprising a plurality of electrostatic lens sub-units. The macro collimator 270 may use a combination of magnetic and electrostatic lenses. Desirably, the macro collimator 270 uses only electrostatic lenses.

In the embodiment of **FIG. 4** a macro scan deflector 265 is provided to cause sub-beams to be scanned over the sample 208. The macro scan deflector 265 deflects respective portions of the beam to cause the sub-beams to be scanned over the sample 208. In an embodiment, the macro scan deflector 256 comprises a macroscopic multi-pole deflector, for example with 8 poles or more. The macro-scan deflector may be electrostatic or magnetic. The deflection is such as to cause sub-beams derived from the beam to be scanned across the sample 208 in one direction (e.g. parallel to a single axis, such as an X axis) or in two directions (e.g. relative to two non-parallel axes, such as X and Y axes). The macro scan deflector 265 acts macroscopically on all of the beam rather than comprising an array of deflector elements that are each configured to act on a different individual portion of the beam. In the embodiment shown, the macro scan deflector 265 is provided between the macro collimator 270 and the control lens array 250.

The electron-optical system of **FIG. 4** further comprises a detector (not shown), for example detector 240 as described above in relation to **FIG. 3****,** desirably the detector may be a detector array.

In some embodiments, as exemplified in **FIG. 5****,** the control lens array 250 is the first deflecting or lensing electron-optical array element in the beam path down-beam of the source 201. Such an embodiment may have a first a beam limiting array 252 to generate a plurality of beams for example from a source beam emitted by the source 201. The beam limiting array 252 may be the first electron-optical element down beam of the source 201. The control lens array 250 may comprise the beam limiting array 252

In the embodiment of **FIG. 5****,** a collimator element array 271 is provided instead of a macro collimator, which may be an electrostatic collimator of two or more plates having single apertures (which may be in the form of a macro collimating lens, for example as an electrostatic lens). The collimator element array 271 may be more spatially compact than a macro collimator 270. Providing the collimator element array 271 and the scan-deflector array 260 together may therefore provide space saving. This space saving is desirable where a plurality of the electron-optical systems comprising the objective lens array assembly are provided in an electron-optical system array. In such an embodiment there may be no macro condenser lens or a condenser lens array. In this scenario the control lens therefore provides the possibility to optimize the beam opening angle and magnification for changes in landing energy.

In some embodiments, as exemplified in **FIG. 5****,** the collimator element array 271 is the first deflecting or focusing electron-optical array element in the beam path down-beam of the source 201.

Avoiding any deflecting or lensing electron-optical array elements (e.g. lens arrays or deflector arrays) up-beam of the control lens array 250 or up-beam of the collimator element array 271 reduced requirements for electron-optics up-beam of the objective lenses, and for correctors to correct for imperfections in such optics. For example, some alternative arrangements seek to maximize source current utilization by providing a condenser lens array in addition to an objective lens array. The provision of a condenser lens array and an objective lens array in this manner results in stringent requirements on position of the virtual source position uniformity over the source opening angle, or requires corrective optics per sub-beam in order to make sure each sub-beam passes through the center of its corresponding objective lens down-beam. Architectures such as that of **FIG. 5** allow the beam path from the first deflecting or lensing electron-optical array element to a beam shaping limiter 242 to be reduced to less than about 10mm, preferably to less than about 5mm, preferably to less than about 2mm. Reducing the beam path reduces or removes the stringent requirements on virtual source position over the source opening angle.

The provision of a scan-deflector array 260 instead of a macro scan deflector can reduce aberrations from the control lenses. This is because the scanning action of the macro scan deflector causes a corresponding movement of beams over a beam shaping limiter (also referred to as a lower beam limiter) defining an array of beam-limiting apertures down-beam of at least one electrode of the control lenses, which increases a contribution to aberration from the control lenses. When a scan-deflector array 260 is used instead the beams are moved by a much smaller amount over the beam shaping limiter. This is because the distance from the scan-deflector array 260 to the beam shaping limiter is much shorter. Because of this it is preferable to position the scan-deflector array 260 as close as possible to the objective lens array 241 (e.g. such that the scan-deflector array 260 is directly adjacent to the objective lens array 241 as depicted in **FIG. 5****.** The smaller movement over the beam shaping limiter results in a smaller part of each control lens being used. The control lenses thus have a smaller aberration contribution. To minimize, or at least reduce, the aberrations contributed by the control lenses the beam shaping limiter is used to shape beams down beam from at least one electrode of the control lenses. This differs architecturally from conventional systems in which a beam shaping limiter is provided only as an aperture array that is part of or associated with a first manipulator array in the beam path and commonly generates the multi-beams from a single beam from a source. In an arrangement, the beam shaping limiter 242 is structurally integrated with an electrode of the objective lens array 241. Desirably, the beam shaping limiter 242 is positioned in a region of low electrostatic field strength. Each of the beam-limiting apertures of the beam shaping limiter 242 is aligned with a corresponding objective lens in the objective lens array 241. The alignment is such that a portion of a sub-beam from the corresponding objective lens can pass through the beam-limiting aperture and impinge onto the sample 208. Each beam-limiting aperture has a beam limiting effect, allowing only a selected portion of the sub-beam incident onto the beam shaping limiter 242 to pass through the beam-limiting aperture. The selected portion may be such that only a portion of the respective sub-beam passing through a central portion of respective apertures in the objective lens array reaches the sample. The central portion may have a circular cross-section and/or be centered on a beam axis of the sub-beam.

In other embodiments, for example variations of the arrangements shown in and described with reference to **FIG. 4-5****,** both the macro scan deflector 265 and the scan-deflector array 260 are provided. In such an arrangement, the scanning of the sub-beams over the sample surface may be achieved by controlling the macro scan deflector and the scan-deflector array 260 together, preferably in synchronization. A variation may comprise both the macro collimator 270 and the collimator array 271, distributing the collimation action through the column.

In an embodiment, an electron-optical system array is provided. The array may comprise a plurality of any of the electron-optical systems described herein. Each of the electron-optical systems focuses respective multi-beams simultaneously onto different regions of the same sample. Each electron-optical system may form sub-beams from a beam of charged particles from a different respective source 201. Each respective source 201 may be one source in a plurality of sources 201. At least a subset of the plurality of sources 201 may be provided as a source array. The source array may comprise a plurality of sources 201 provided on a common substrate. The focusing of plural multi-beams simultaneously onto different regions of the same sample allows an increased area of the sample 208 to be processed (e.g. assessed) simultaneously. The electron-optical systems in the array may be arranged adjacent to each other so as to project the respective multi-beams onto adjacent regions of the sample 208. Any number of electron-optical systems may be used in the array. Preferably, the number of electron-optical systems is in the range of from 9 to 200. In an embodiment, the electron-optical systems are arranged in a rectangular array or in a hexagonal array. In other embodiments, the electron-optical systems are provided in an irregular array or in a regular array having a geometry other than rectangular or hexagonal. Each electron-optical system in the array may be configured in any of the ways described herein when referring to a single electron-optical system. As mentioned above, the scan-deflector array 260 and collimator element array 271 are particularly well suited to incorporation into an electron-optical system array because of their spatial compactness, which facilitates positioning of the electron-optical systems close to each other.

In some embodiments, for example as exemplified in **FIG. 5****,** the objective lens array assembly which is a unit that comprises the objective lens array 241) further comprises a beam shaping limiter 242. The beam shaping limiter 242 defines an array of beam-limiting apertures. The beam shaping limiter 242 may be referred to as a lower beam shaping-limiting aperture array or final beam-limiting aperture array. The beam shaping limiter 242 may comprise a plate (which may be a plate-like body) having a plurality of apertures. The beam shaping limiter 242 is down-beam from at least one electrode (optionally from all electrodes) of the control lens array 250. In some embodiments, the beam shaping limiter 242 is down-beam from at least one electrode (optionally from all electrodes) of the objective lens array 241.

In some embodiments, the charged particle device 41, for example as shown in and described with reference to **FIG. 5****,** further comprises an upper beam limiter 252, for example in addition to the beam shaping limiter 242. The upper beam limiter 252 defines an array of beam-limiting apertures. The upper beam limiter 252 may be referred to as an upper beam-limiting aperture array or upbeam beam-limiting aperture array. The upper beam limiter 252 may comprise a plate (which may be a plate-like body) having a plurality of apertures. The upper beam limiter 252 may be a beam limiting array. The upper beam limiter 252 forms sub-beams from a beam of charged particles emitted by the source 201. Portions of the beam other than those contributing to forming the sub-beams may be blocked (e.g. absorbed) by the upper beam limiter 252 so as not to interfere with the sub-beams downbeam. Charged particles projected through apertures in the upper beam limiter 252 may from sub-beams. The upper beam limiter 252 may be referred to as a sub-beam defining aperture array.

Any of the objective lens array assemblies described herein may further comprise a detector 240 having any of the features as described. The detector detects electrons emitted from the sample 208. The detected electrons may include any of the electrons detected by an SEM, including secondary and/or backscattered electrons emitted from the sample 208.

**FIG. 6** schematically depicts a charged particle assessment system 40 according to an embodiment. Features that are the same as those described above are given the same reference numerals. For conciseness, such features are not described in detail with reference to **FIG. 6****.** For example, the source 201, the condenser lenses 231, the macro collimator 270, the objective lens array 241 and the sample 208 may be as described above.

As described above, in an embodiment the detector 240 is between the objective lens array 241 and the sample 208. The detector 240 may face the sample 208. Alternatively, as shown in **FIG. 6****,** in an embodiment the objective lens array 241, which comprises the plurality of objective lenses, is between the detector 240 and the sample 208. The detector 240 may have all the features of the earlier described embodiments for example with reference to **FIGs. 3** **and** **5**, except as herein described.

In an embodiment a deflector array 95 is between the detector 240 and the objective lens array 241. In an embodiment the deflector array 95 comprises a Wien filter (or even a Wien filter array) so that deflector array may be referred to as a beam separator. The deflector array 95 is configured to provide a magnetic field to disentangle the charged particles projected to the sample 208 from the secondary electrons from the sample 208. However, it is preferable that the system comprises electrostatic components, rather than magnetic components.

In an embodiment the detector 240 is configured to detect signal particles by reference to the energy of the charged particle, i.e. dependent on a band gap. Such a detector may be a semiconductor based detector such as a PIN detector or a scintillator (which is optically connected to a photonic converter or photon to electron converter. Such a detector 240 may be called an indirect current detector. The secondary electrons emitted from the sample 208 gain energy from the fields between the electrodes. The secondary electrodes have sufficient energy once they reach the detector 240.

The control lens array 250 may be in the same module as an objective lens array 241, i.e. forming an objective lens array assembly or, in one type of terminology, as part of the objective lens array, or it may be in a separate module

In some embodiments for example of any of the embodiments described with reference to and shown in **FIGs 3****,** **5** **and** **6**, one or more aberration correctors are provided that reduce one or more aberrations in the sub-beams. The one or more aberration correctors may be provided in any of the embodiments, e.g. as part of the charged particle-optical device, and/or as part of an optical lens array assembly, and/or as part of an assessment system, and/or as part of an electron-optical arrangement. In an embodiment, each of at least a subset of the aberration correctors is positioned in, or directly adjacent to, a respective one of the intermediate foci (e.g. in or adjacent to the intermediate image plane). The sub-beams have a smallest cross-sectional area in or near a focal plane such as the intermediate plane. This provides more space for aberration correctors than is available elsewhere, i.e. upbeam or downbeam of the intermediate plane (or than would be available in alternative arrangements that do not have an intermediate image plane).

In an embodiment, aberration correctors positioned in, or directly adjacent to, the intermediate foci (or intermediate image plane) comprise deflectors to correct for the source 201 appearing to be at different positions for different beams. Correctors can be used to correct macroscopic aberrations resulting from the source that prevent a good alignment between each sub-beam and a corresponding objective lens.

The aberration correctors may correct aberrations that prevent a proper column alignment. Such aberrations may also lead to a misalignment between the sub-beams and the correctors. For this reason, it may be desirable to additionally or alternatively position aberration correctors at or near the condenser lenses 231 (e.g. with each such aberration corrector being integrated with, or directly adjacent to, one or more of the condenser lenses 231). This is desirable because at or near the condenser lenses 231 aberrations will not yet have led to a shift of corresponding sub-beams because the condenser lenses are vertically close or coincident with the beam apertures. A challenge with positioning correctors at or near the condenser lenses, however, is that the sub-beams each have relatively large sectional areas and relatively small pitch at this location, relative to locations further downstream. The aberration correctors may be CMOS based individual programmable deflectors as disclosed in EP2702595A1 or an array of multipole deflectors as disclosed EP2715768A2, of which the descriptions of the beamlet manipulators in both documents are hereby incorporated by reference.

In some embodiments, each of at least a subset of the aberration correctors is integrated with, or directly adjacent to, the objective lens array 241. In an embodiment, these aberration correctors reduce one or more of the following: field curvature; focus error; and astigmatism. Additionally or alternatively, one or more scanning deflectors (not shown) may be integrated with, or directly adjacent to, the objective lens array 241 for scanning the sub-beams 211, 212, 213 over the sample 208. In an embodiment, the scanning deflectors described in US 2010/0276606, which document is hereby incorporated by reference in its entirety, may be used.

As shown in **FIG. 2** (when read in context of the charged particle devices 41 as depicted in and described with respect to **FIGs 3 to 6**), in an embodiment the projection assembly 60 optionally comprises an optical system 63. In an embodiment, the projection system 60 comprises a light source 61. The light source 61 is configured to emit the light beam 62. As mentioned above the projection assembly 60 is used to illuminate a light beam 62 on the sample 208 so as to control the accumulated charges due to effects such as photoconductivity, photoelectric, or thermal effects; and thus regulate the accumulated charges on the sample.

In an embodiment the optical system 63 comprises a cylindrical lens 64. The cylindrical lens 64 is configured to focus the light beam 62 more in one direction than in an orthogonal direction. The cylindrical lens increases the design freedom for the light source 61. In an embodiment the light source 61 is configured to emit a light beam 62 having a circular cross section.

It is not essential for a cylindrical lens 64 to be provided. In an alternative embodiment another optical component can be used that is capable of focusing more strongly in one direction than another. In an alternative embodiment, the light source is configured to emit a light beam 62 that is elliptical or rectangular, for example. This is desirable to ensure the light beam reaches a portion of the sample required to be illuminated despite the small dimension between the sample and the most downbeam surface of the charged particle device 41 and the large dimension of the downbeam surface of the electron-optical device orthogonal to the orientation of the beam path.

In an embodiment the optical system 63 comprises reflecting surfaces 65, 66 such as mirrors. For example two reflecting surfaces 65, 66 may be provided. In an alternative embodiment, the optical system 63 does not reflect the light beam 62. The number and arrangement of the reflecting surfaces may be chosen depending on the dimensions of the volume in which the projection system 60 is required to fit. Such reflection surfaces may be desirable to improve the reach of the light beam 62 between the most downbeam surface of the charged particle device and the sample.

The projection optical assembly 60 may be present as one or more other embodiments, In an arrangement the path of the light from the light source 61 may be at least partly through the charged particle device 41 for example the path of the light may enter the charged particle device up beam of the objective lens array 240 and be reflected by a reflecting surface 65 within the charged particle device 41 towards the sample for example through the apertures defined in the plates defining the objective lens array and other charged particle-optical elements of the charged particle device. In an embodiment the light source may be proximate the source 201, for example around the source 201 and or adjacent the source so that the path of the light towards the sample passes through all the elements of the charged particle device 41. In another embodiment, the path of the light is through light guides from the light source to the objective lens array for example as disclosed in EP 22204243.4 filed on 27 October which is hereby incorporated by reference at least so far as the disclosure of optical light guides for outcoupling light towards a sample. The light may be outcoupled to illuminate the sample, from a position closer to the path of beams 211, 212, 213 than as depicted in and described with reference to Fig 2. Additionally or alternatively the light be coupled into optical light paths in a charged particle element (e.g. facing element) proximate, such as facing, a sample 208 during operation. The light be outcoupled proximate or from apertures defined in the facing element.

The invention herein disclosed may be applied to various different tool or charged particle apparatus architectures. The charged charged particle apparatus comprises a plurality of columns of multi-beams (or devices of multi-beams). Each column may be a charged particle device, for example an charged particle device 41, described in any of the above embodiments or aspects. As a plurality of columns (e.g., compromised in a multi-column apparatus) which may be a plurality of devices (or a multi-device array), the devices may be arranged in an array which may number two to one hundred devices or more (or may be in two to one-hundred columns). The charged particle apparatus may take the form of an embodiment as depicted in **FIG. 4****,** which is an apparatus comprising a plurality of the charged particle devices 41 as described above with reference to **FIG. 5****.** The charged particle apparatus preferably has an electrostatic scan deflector array and an electrostatic collimator array. A charged particle device may optionally comprise a source. Note in a different arrangement, the devices in the multi-device array may take any suitable design such as shown in and described with reference to **FIGs. 3** **or** **6** (not shown).

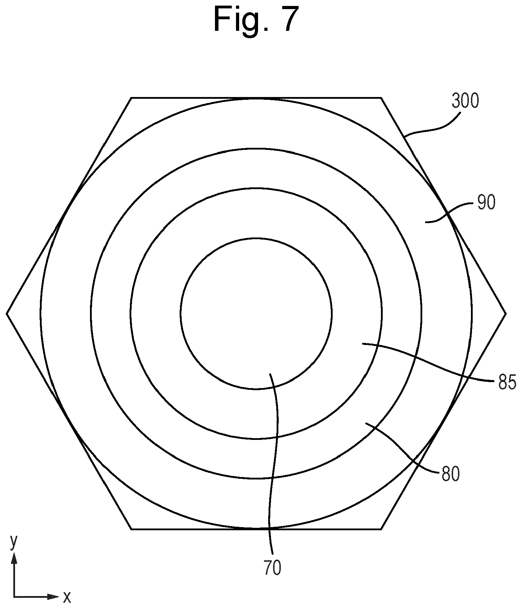

**FIG. 7** illustrates a plan view of an element 300, for example an element defining an array of apertures, such as an electron-optical element for interacting with charged particles, such as operating on charged particles for example of the primary beams. Such an electron optical element may be of one or more of the following features: an objective lens array or condenser lens array or part thereof such as the lens arrays 231, 241, 250; a collimator 235, 271, 270 such as a collimator array 235, 271 which may collimate by lensing such as lensing collimator 235, 270 and/or by deflecting 271; a scan deflector array 260, 265; a limiting aperture array 231, 242, 252 for generating and/or shaping charged particle beams; or a detector array 240 for detecting charged particle of the primary beam and/or from a sample 208. The element 300 is comprised in a charged particle device 41. In an arrangement the element may be across the entire cross-section of the charged particle device 41.

Each of the aspects depicted in **FIG. 3 to 6** as described above include a charged particle device 41 comprising a source 201. The source is configured to emit a respective source beam of charged particles along a respective path of a beam grid towards the sample. The beam grid comprises a plurality of charged particle beams. The element 300 is configured to interact with charged particles for example operate on the charged particle beams in the beam grids of the individual source beam. The element 300 comprises a beam area 70 assigned to the source beam originating from the source 201 of the charged particle device 41. The beam area 70 is an area on a surface of the element 300 which is spanned by the beam grid. In the element may be defined one or more apertures. The apertures may correspond to a beam path of the beam grid, groups of beam paths of the beam grid or all the beam paths of the beam grid (i.e. the path of the beam grid).

The element 300 may be separated from an adjoining element, disposed downbeam of the element 300 by a spacer 80. The element 300 and the adjoining element may, for example, be electrodes. In particular, the element 300 and the adjoining element may be a pair of electrode plates. The element and the adjoining element may comprise at least part of a lens array, such as a control lens array 250 or condenser lens array 231. The spacer may provide physical separation between the element 300 and the adjoining element in a direction of the path of the beam grid. The spacer may support an element to which it is connected, such as the element 300 and the adjoining element. In a stack of elements (e.g. a plurality of elements layered on each other with interleaving spacers),the spacers may provide structural or mechanical rigidity to the stack of elements. The spacer may thermally insulate the elements from each other, such as the element 300 from the adjoining element. The spacer may be electrically isolating, for example electrically isolate elements to which it is connected for example the element 300 and the adjoining element. In a different embodiment, the spacer may be conductive so that there no potential difference is applied between the connected elements, for example between the element 300 and the adjoining element; that is the connected elements have the same potential difference relative to other elements of the charged particle device 41.

**FIG. 7** illustrates a spacing area 85. The spacing area 85 is disposed between 70 and 80 is a part of substrate of element 300. The spacing area 85 may be dimensioned to be of sufficient size between the beam area and the spacer, and may be empty of features, to reduce the likelihood of unwanted discharge for example at the surface of the spacer 80. The spacing area 85 optionally includes dummy apertures to suppress edge effects around the beam area and/or vent holes for fluid conductance, pressure control and contamination suppression. The spacing area 85 covers the distance between the beam area 70 and the closest spacer 80. The shortest distance between the beam area 70 and the closest space 80 to that beam area 70 is desirably greater than or equal to a predetermined threshold distance which is great enough to limit the likelihood of unwanted discharge.

**FIG. 7** illustrates an access area 90 which represents a region of the charged particle device 41 used to provide: service connections to one or more elements of the charged particle device 41 for example electrical connections, connections for control and data signals, cooling fluids; feedthroughs; connection between the service connections and feedthrough; and to gain access to components, for example during maintenance.

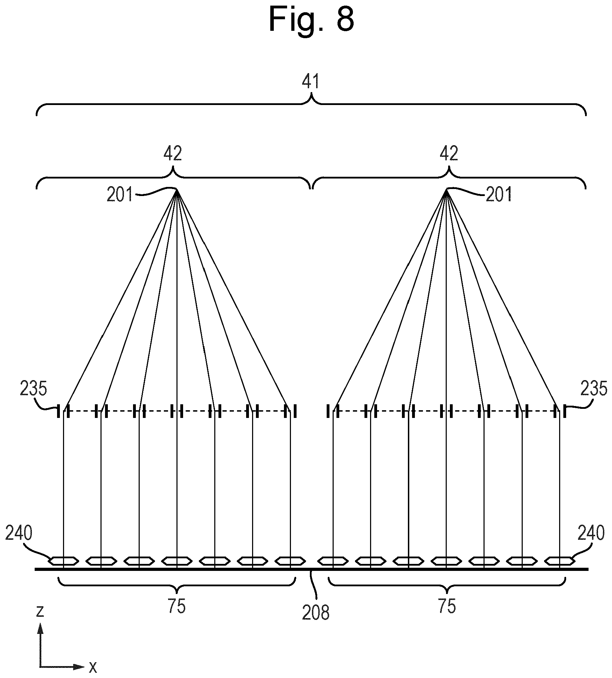

The invention herein disclosed may be applied to various different charged particle apparatus architectures. As shown, for example, in **FIG. 8****,** the charged particle device 41 comprises a plurality of sub-devices 42 wherein, each sub-device 42 may described in any of the above embodiments or aspects. As a plurality of devices (or a multi-device array for example comprised in a multi-device apparatus), the devices may be arranged in an array which may number two to one hundred devices or more. Such a device 41 may be referred to as a multi-device 41 (or charged particle multi-device).

The charged particle device may take the form of an embodiment as depicted in **FIG. 8****,** which is a charged particle device comprising a plurality of the sub-devices 42, with reference numerals taking the meanings described above in reference to **FIG. 3****.** The charged particle device preferably has an electrostatic scan deflector array and an electrostatic collimator array. A charged particle device 41 comprises a plurality of sources 201. Note in a different arrangement, the devices in the multi-device array may take any suitable design such as shown in and described with reference to **FIGs. 4 to 6** (not shown). Each source 201 is configured to emit a respective source beam of charged particles along a respective path of a beam grid towards the sample 208. The beam grid comprises a plurality of charged particle beams, which may be referred to as sub-beams or beamlets.

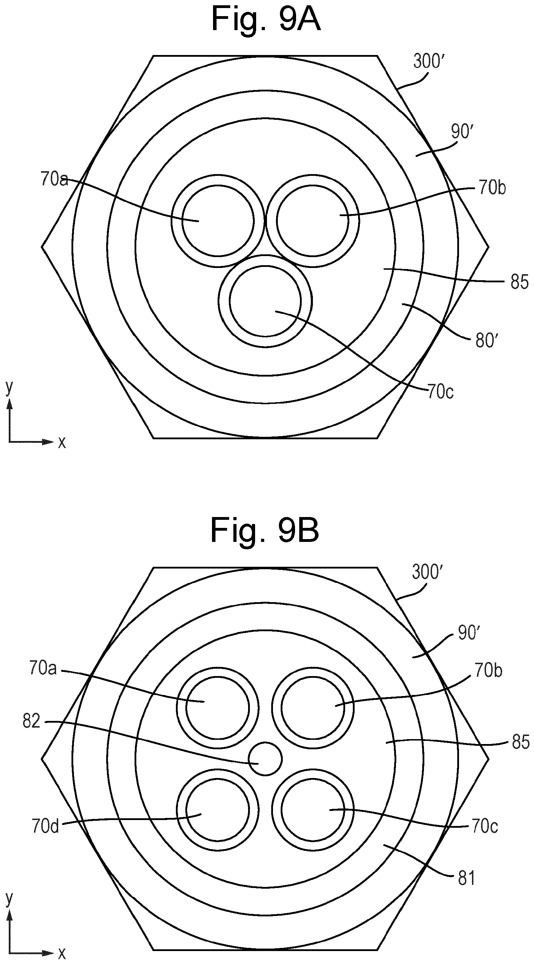

With an arrangement having a plurality of sub-devices, such as the arrangement of **FIG. 8****,** it is possible to reduce the number of components in comparison to a system comprising a plurality of separate charged particle devices, each having a corresponding source, in order to provide a comparative number of beam areas. In this way, as shown for example in **FIG. 9A-C** (which provides a plan view of an element 300', which may have an equivalent electron-optical function to the element 300 of **FIG. 7**), with an arrangement such as that of **FIG. 8****,** there may be a plurality of beam areas each corresponding to one of a plurality of sources. It is noted that with **FIGs 9A-C** that common references in these different figures are indicative of similar features, which may be of different dimensions in the different embodiments (for example with similar size beam areas).

Each beam area may correspond to a different source, for example the surface of the element 300' assigned to the beam grid derived from a source . The surface area of an element 300, 300' assigned to a beam area and a respective beam grid may be larger than required by the beam grid This is depicted for example in FIGs 9A to 9C by the different beam gird 70a to 70e having an outer concentric boundary forming an annulus or ring around the periphery of the respective beam area. This annular region desirably ensures s sufficient space between adjacent beam areas to account for alignment tolerances and to reduce the likelihood of interference (or cross talk) between adjoining beam grids. For example, an annular region, around or of the periphery of each beam area assigned to the specific beam area. The annular region may be considered to be of the assigned beam area; the features of the annular region may be indistinguishable from the portion of a beam area for actual use by the beam grid (desirably so that alignment variations between different beam gird and their respect beam areas enable the beam grids to be projected through the element 300' without distinguishable variation or difference between the different beam grids ; that is the alignment variations may be within the tolerances permitted by the annular regions of adjoining beam areas). The annular region may be for example between an outer periphery of the beam area and the outer periphery of an active part of the beam area through which the respective beam grid passes. The annual region of each beam grid may be considered to be part of the spacing region between the path of the beam grid and an adjoining spacer, for example the shortest distance between the periphery of an active part of the beam gird and the closest surface of a spacer; although features of the annular region within the spacing region may have the features of the beam grid rather than the rest of the spacing region..

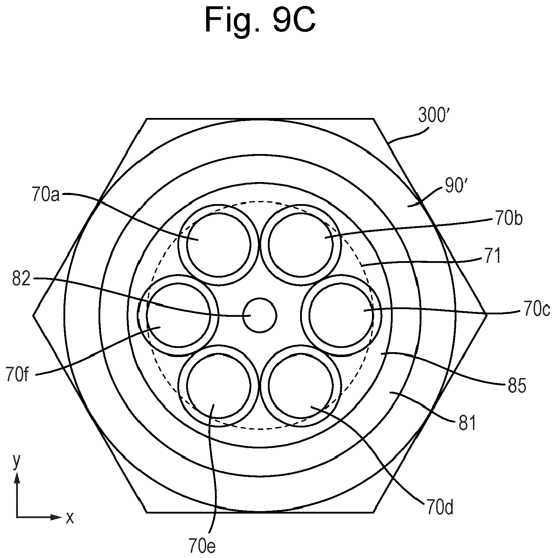

For example **Fig 9A** depicts three beam areas 70a-c that may be equidistantly spaced apart; **Fig 9B** depicts four beam areas 70a-d that may be equidistantly spaced apart at least from adjacent beam areas; **Fig 9C** depicts six beam areas 70a-f in which the beam areas are equidistantly spaced apparat from adjacent beam areas. There may be as many different beam areas as desired. Despite there being more beam areas some features and components of the element 300' may be maintained or increased to a lesser extent than the number of beam areas. That is the number of components and features is fewer than would be expected if the plurality of beam areas is achieved by having separate charged particle device 41 with separate elements 300'.

Reducing or preventing the number of such components features corresponding to the number of beam areas (e.g. reducing the number of components and features from what would be expected if separate elements for different beam grid paths were used), multiple beam areas may be provided in a more compact area. The access area required to operate and maintain such a multi-device may be desirably reduced. (This assumes that the size of the beam areas are the same as when individual elements 300 or at least access areas 90 are provided for the different beam areas). For example, the access area 90 of **FIG. 7** corresponds to a single beam area 70, whereas in the arrangements of **FIG. 9A-C** there is a single access area 90' for a plurality of beam areas, for example the three beam areas 70a-c of **FIG. 9A****.** In an arrangement in which the beam area 70 of FIG. **7** is the same as a beam area 80' of **FIG 9A****,** although that need not be the case, the size of the access area 90' is not significantly increased (in **FIG. 9A** comparted to the access area 90 of **FIG. 7**), if it is not the same area. Having multiple beam areas means the total beam area may be significantly larger, for example expressed as a density over the total area of the element(s) 300', or per unit area of an element.

In an arrangement comprising a plurality of beam areas 70a-c, such as the arrangement of **FIG. 9A****,** each beam area 70a, 70b, 70c may have the same size, or area, as the corresponding beam area 70 of an arrangement, such of that of **FIG. 7****,** wherein there is only one beam area 70. Alternatively, the beam areas 70a-c of an arrangement having a plurality of beam areas, may be a different size or area than the corresponding beam area 70 of an arrangement, such of that of **FIG. 7****,** wherein there is only one beam area 70. Furthermore, the plurality of beam areas 70a-c may include beam areas of different sizes. In other words there may be more than one size, or area, of beam area within the same charged particle device 41. It is desirable that all of the beam areas 70a-c of the plurality of beam areas are the same size, or cover the same area on the element 300'.

In an arrangement, the access area 90' per beam area may be proportionately smaller the greater the number of beam areas present in an element 300'. In this way the total size of the access area 90' compared to the area of sample which can be assessed simultaneously by the device can be reduced, thus increasing throughput. That is, the proportional of the area of an element assigned to the access area 90' of the multi-device is smaller for the arrangements with multiple beam areas e.g. as described and depicted with reference to **FIGs 9A-9C**; desirably the proportional size of the access area 90' reduces with an increasing number of beam areas (even though the dimension of the element 300' (for example across the multi-device) may increase with increasing number of beam areas.. Thus the proportional size of the element 300' assigned to a beam area, and for operating on the beams of the beam grids of the multi-device, is larger with a plurality of beam areas compared to a single beam area 70, for example may increase with an increasing number of beam areas.

As mentioned, often the size of the assessment system for example the area (or footprint) required to accommodate such an assessment system in a production facility is determined by the area required for operation of the stage with the charged particle devices of the assessment system to scan a sample. The more charged particle devices an assessment system has, the larger its area (or footprint). Since the available footprint for such an assessment systems in a production facility of a chip fabrication plant is limited, the number of charged particle devices that can be present in an assessment system with an array of charged particle devices for scanning sample of a typical size may be limited. The present invention, by enabling a denser arrangement of beam areas within the device 41, therefore enables an increase throughput of samples of such an assessment system.

It should be noted that this discussion so far considers that the effect is the same for all elements of the multi-device. However, the required beam area for elements at different positions of the path of charged particles from the source 201 to the sample 208, or at least the collimator 235 (270, 271) increases in size with distance from the source. The source beam and, when present up beam of the collimator, the beams of the beam grid diverge. Between the collimator 235, 270, 271 and the sample the different beams are substantially collimated. Between the surface of a device 41 for facing the sample and the collimator, the beam area may be similar if not the same between different, for example adjacent, element 300. Such elements may be electron-optical elements such as the collimator 235, 270, 271, the detector array 240, lens electrode of an objective lens array 241 and a control lens array 250, scan deflectors 260, 265, and beam limiting aperture arrays 242, 252. Elements between the source 201 and the collimator 235, 270 may have beam areas that are smaller than the beam areas of a collimator in the same charged particle device 41. Such elements 300 that may be between the collimator and the source may be: a condenser lens array 231 and its constitute or associated beam limiting aperture array, and any other element such as a corrector which may be positioned in the diverging path of charged particles from the sources 201.

Unlike the arrangement of **FIG. 7****,** in the arrangements of **FIG. 9A-C****,** the element 300' comprises a plurality of beam areas, wherein each beam area is assigned to an individual source beam from an individual source, from among the plurality of sources 201 such as shown in the arrangement of **FIG. 8****.** The element 300' is configured to operate on the charged particle beams in the beam grids of the individual source beam. There may be a plurality of elements, in particular there is desirably an adjoining element disposed directly upbeam or downbeam of the element 300'.

As discussed above, although each beam area in a multi-device 41 such as shown in **FIG. 8** (i.e. in a device 41 having a plurality of sources 201), corresponds to an individual beam grid corresponding to a particular one of the plurality of sources 201, some other components of the device 41 are desirably shared among the different beam areas. For example, the device may comprise a spacer 80' disposed between the element 300' and an adjoining element. The spacer may comprise a support. The support is desirably disposed between the element 300' and the adjoining element for supporting the element and/or the adjoining element. As shown for example in **FIG. 9A****,** the spacer 80' has at least one aperture positioned to correspond to the position of at least two beam areas, for example a single aperture around all beam areas 70a, 70b, 70c, e.g., a plurality of beam areas. In the example of **FIG. 9A****,** the aperture defined by the spacer 80' is positioned to correspond to, for example circumscribe or surround, three beam areas 70a-c. In an alternative arrangement, the aperture defined by the spacer is positioned to correspond to e.g. surround, for example, between two and six beam areas.

As shown for example in **FIG. 9B****,** the spacer may comprise an outer support 81 having an aperture positioned to correspond to a plurality of beam areas 70a-d. As shown in **FIG. 9B****,** the aperture of the outer support 81 may be positioned to correspond, or surround, to four beam areas for example a single aperture around all beam areas 70a, 70b, 70c, 70d, e.g. a plurality of beam areas. In other words, the aperture of the spacer may surround a plurality of beam grids emitted by a plurality, for example four, sources 201. In an alternative arrangement, the outer support 81 may have an aperture positioned to correspond to, or surround, two or more beam areas, for example between two and six beam areas.

The outer support 81 of **FIG. 9B** defines a circular aperture. Alternatively, the aperture defined by the outer support 81 may not be circular, for example it may be a rectangle, an oval, hexagonal or an elliptical shape, or may be shaped to correspond to the beam grids which are surrounded by the outer support 81.

The plurality of beam areas are optionally arranged in a two dimensional array. Desirably the two dimensional array has a pattern. As shown for example in **FIG. 9B****,** the two dimensional array may comprise comprising at least 2 parallel rows of beam areas, wherein each row comprises at least 2 beam areas. Alternatively, as shown for example in **FIG. 9C****,** the plurality of beam areas may have a pattern comprising an annulus for example around a central position of the of beam areas. The plurality of beam areas may comprises at least one annulus of beam areas. For example, the at least one annulus of ring areas may be a ring 71 of beam areas. The pattern may define that each beam area 70b that is equidistantly spaced away from its adjacent or neighboring beam areas 70a, 70c, for example in the annulus. Hereafter the term ring is used to describe the arrangement of beam areas such as depicted in **FIG. 9C****.** However, in alternative arrangements, the beam areas may be arranged surrounding a central point. The arrangement of beam areas may be circular and may form an annulus, in particular a ring, or may be non-circular, for example the three beam areas 70a-c of **FIG. 9A****.**

In the arrangement of **FIG. 9C****,** the ring 71 of beam areas may be positioned around a central position of the plurality of beam areas for example in an annulus such as a two dimensional ring around the central position. The central position may be disposed at a midpoint between the plurality of beam areas, for example the central position may be equidistant from each of the plurality of beam areas surrounded by the outer support 81. The beam area may be equidistantly spaced away from its adjacent or neighboring beam areas 70a, 70c, for example in the annulus. In other words, in both the arrangement of **FIG. 9B** and **FIG. 9C****,** the two dimensional array comprises beam areas arranged around a mid-region. The mid-region in these examples being at a central position of the plurality of beam areas. For example in the arrangement of **FIG. 9C** the two dimensional array an annulus of beam areas, the annulus forming a ring 71 of beam areas.

As shown for example in **FIG. 9B** and **FIG. 9C****,** the spacer optionally comprises an inner support 82 disposed between the element 300' and the adjoining element for supporting the element and/or the adjoining element. A periphery of the inner support 82 is surrounded by more than two of the beam areas. In an embodiment as depicted in **FIG. 9B** the inner support 82 is surrounded by four beam areas. In an embodiment as depicted in **FIG. 9C** the inner support 82 is surrounded by six beam areas 70a-f. In the arrangements of **FIG. 9B** and **FIG. 9C****,** the inner support 82 may be positioned at a central position at a midpoint of the plurality of beam areas. There may be more than one inner support of which one may be located at the central position; in a different arrangement all the central supports are positioned away from the central position, desirably within the outer support 81.

The inner support 82 desirably provides sufficient support for the element 300' to enable the beam areas (or the regions of adjacent elements defining adjacent beam areas) to be spaced apart such that the outer support 81 defines an aperture having a larger diameter than that of the arrangement of **FIG. 9A****.** In the arrangement depicted by **FIG. 9A****,** there is a single support, the outer support 81 . As such, the outer support 81 supports the element 300' and/or the adjoining element such that a gap between the element and he adjoining element is maintained, for example above a threshold distance; that is the space (for example defined by the gap) between the element and adjoining element is maintained above or to a threshold distance, for example in a mid-region of the space, element and/or the adjoining element. So the gap is not overly reduced in the mid-region which may be a risk of discharge. With an arrangement as depicted and described with reference to **FIG. 9A****,** the diameter of the aperture defined by the outer support 81 may have a threshold diameter defining a maximum acceptable diameter. This may mean that the diameter of the aperture cannot exceed the threshold diameter beyond which the element 300'; otherwise the element and the adjoining element, for example at the mid-region, would not be at risk of sufficient support, and of increased risk of discharge. As such, the beam areas 70a-c in the arrangement of **FIG. 9A** are closely spaced together compared to the beam areas 70a-d of the arrangement of **FIG. 9B****.** In the arrangement of **FIG. 9B****,** the inner support 82 provides support for the element 300' in the mid-region for example between such as equidistant from the surrounding beam areas. As such, the diameter of the aperture of the outer support 81 for example surrounding four beam areas as shown in and a described with reference to **FIG. 9B** may be greater than that the aperture of a spacer surrounding fewer beam areas such as with three beam areas as depicted in **FIG. 9A****.**

Optionally, in an alternative arrangement, in the inner support may be defined one or more apertures. Such an aperture may be disposed to correspond to, or surround, one or more beam areas. For example, the plurality of beam areas may comprise a central beam area for example with respect to the respective aperture for example disposed in the mid-region of the element. The central beam area is desirably disposed at the central position. The central beam area is optionally surrounded by the inner support. Such an inner support may have the same features as described for the outer support 81 shown in and described with reference to **FIGs 7****,** **9A-C****.**

In arrangements multi-device 41 comprising elements 300' such as shown in and described with reference to **FIG. 9A-C****,** there may be a plurality of sub-devices 42. The number of sub-devices 42 in the charged particle multi-device 41 may be used to provide coverage of many charged particles beams over a sample surface, for example to simultaneously scan a sample, such as a sample having an industrial standard size, for example a diameter of 300 mm. The time required for such a multi-device 41 may be reduced compared to using a plurality of charged particle devices 41 having just a single source and a single beam area e.g. rather than a source array with a plurality of beam areas. At present, there is a limit to the beam current which a single source may generate. Using a plurality of sources effectively enables the beam current to be increased, without increasing the beam current per source. Further, compared to scanning of the sample by a charged particle device 41 with just one source, the sample area scanned per unit time by a multi-source 41 would be greater; that is a surface area of a standard sample would be scanned in a shorter time. The throughput of a multi-device 41 would be greater than for a known device having a single source. The inclusion of a plurality of beam areas per device 41 (e.g. as a multi-device) thus may reduce the costs by reducing the total number of devices used per sample. Further, having the multi-source generate beam areas with a greater density than known designs of multi-device, enables such a multi-device to have a greater proportion of its cross-section as beam areas; scanning of sample surface by such a multi-device is likely to be faster for a greater throughput. Arranging the plurality of beam areas per multi-device 41 with a greater density may further reduce scanning time required per sample for example costs of goods.

Within the inner support may be one or more further inner supports which may have the same features of the inner support shown in and described with reference to **FIGs 9B-C****.** The outer support 81, the inner support 82 and the further inner support may be referred to a support arrangement, such as a concentric support arrangement. Such a concentric support arrangement may have as many support elements as required; there may be at least two concentric elements with a common axis for example at the central position. However it is desirable for the support arrangement to have a few support elements for example to optimize, desirably maximize the proportional size of the beam areas relative to the elements.

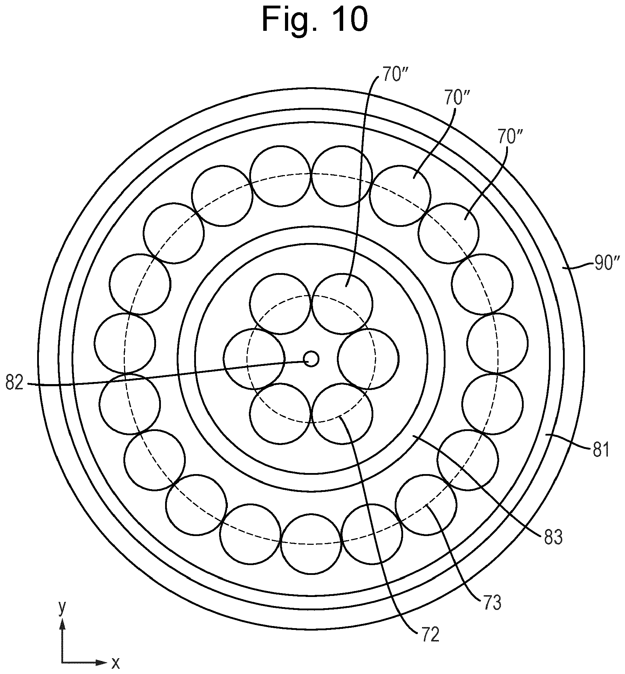

Another alternative exemplary arrangement is illustrated in **FIG. 10****.** The arrangement of **FIG. 10** includes a plurality of beam areas 70", a spacer and an access are 90". Similarly to the arrangement of **FIG. 9C****,** there is at least one annulus of beam areas, which is depicted as a ring of beam areas. The arrangement of **FIG. 10** comprises an inner annulus 72 (or inner ring) of beam areas arranged adjacent to the central position. The inner ring 72 of beam areas of **FIG. 10** comprises six beam areas. In an alternative arrangement the inner ring may comprise between one and six beam areas.

The arrangement of **FIG. 10** further comprises an outer ring 73 of beam areas. The outer ring 73 of beam areas surrounds the inner ring 72 of beam areas. The outer ring 73 of beam areas is positioned concentrically around the inner ring 72 of beam areas. In the arrangement of **FIG. 10****,** the outer ring of beam areas comprises nineteen beam areas. In an alternative arrangement the outer ring may comprise any number of beam areas for example between six and twenty beam areas, for example more than the number of beam areas within the inner ring 72. Furthermore, an alternative arrangement may optionally comprise a plurality of rings, such as one or more further rings, of beam areas. The further rings may be disposed concentrically surrounding the outer ring, such that the outer ring may be between the inner ring and the further rings. For example in an arrangement there may be up to four rings, including the inner ring having up to 6 beam areas: the outer ring may have up to 20 beam areas; there may be two further rings for example having up to 33 and up to 46 beam areas respectively. The plurality of rings may be disposed over a sample having a diameter of 300 mm. A charged particle device 41 (or multi-device) may have more than 100 sources 201 (for example up to 105 sources 201); so for example there may be more than 100 sub-devices 42. The different sources 201 may emit charged particles which impact a sample having a beam grid having a corresponding beam area 75 ; noting the beam area may be smaller in the part of a sub-device 42 having a diverging charged particles. The plurality of beam areas of the beam grids of the different sub-devices 42 may be provided over a single sample, for example the sub-devices may be configured to scan the sample, desirably simultaneously.

In the arrangement of **FIG. 10****,** the spacer further comprises an intermediate support 83 disposed between the element and the adjoining elements for supporting the element and/or the adjoining element. In particular, in the arrangement of **FIG. 10****,** the intermediate support 83 configured to surround the inner ring 72 of beam areas. The intermediate support 83 is surrounded by the outer ring 73 of beam areas. The arrangement of **FIG. 10** comprises an outer support 84 configured to surround the outer ring 73 of beam areas. In an alternative arrangement, the outer support may not be included because the intermediate support may provide sufficient support to the element and adjoining element such that the element and adjoining element. Furthermore, as shown for example in **FIG. 10****,** the spacer may include an inner support 82 which is desirably disposed at the mid-region and more desirably the central position.

In the arrangement of **FIG. 10****,** the intermediate support 83 defines one of the at least one apertures defined by the spacer. The intermediate support 83 is positioned to correspond to the inner ring 72 of beam areas 70". In an alternative arrangement, the intermediate support may have a contiguous surface that is without an aperture. The intermediate support may be positioned between at least one beam area of the inner ring 72 of beam areas and at least one beam area of the outer ring 73 of beam areas. The intermediate support may comprise a plurality of discrete support structures disposed around the inner ring of beam areas. In this way, the intermediate support provides support for the element between the inner ring 72 and the outer ring 73.

The intermediate support is optionally positioned between two adjoining beam areas, for example equidistant between two or more beam areas. Desirably the position of the intermediate support corresponds to the mid-region. Desirably the intermediate support surrounds one or more of the beam areas. The intermediate support may define one or more of the apertures. For example, the intermediate support may define a plurality of apertures. Each aperture of the intermediate support may correspond to, or surround, at least one beam area. Desirably, each aperture of the intermediate support may surround two or more adjacent beam areas.

The elements are desirably configured to be positioned such that the array of apertures is disposed along the path of the beam grid. The element 300, 300' may for example be an electrode of a lens array. The electrode is desirably an electrode plate. The lens array optionally comprises the adjoining element and the spacer.

The spacers 80', 81, 83 in **FIGs 9A-C** **and** **10** are shown as being continuous and surrounding a plurality beam areas. Instead of being continuous, the spacers may be a plurality of discrete support structures disposed at positions around the plurality of beam areas.

Each arrangement of beam areas such as shown in **FIG. 9A-C** and **FIG. 10** corresponds to a different charged particle sub-device 42 having a different number of sources 201. The number of beam areas may correspond to the number of sub-devices 42. In particular, the charged particle device 41 associated with **FIG. 9A** comprises three sources 201; whereas the charged particle device 41 associated with **FIG. 9B** comprises four sources 201; the charged particle device 41 associated with **FIG. 9C** comprises six sources 201. The charged particle device 41 associated with **FIG. 10** comprises 25 sources 201.

Having a densely arranged beam areas in the multi-device 41, enables multiple multi-device 41 for example of the same design of multi-device may be scanned over a sample. Such an arrangement may increase throughput. For example up to seven (7) of the charged particle devices 41 with the arrangement of multiple beam areas shown in **FIG. 9A** may be disposed facing a single sample having a standard diameter of for example 300 mm. Desirably the charged particle device 41 is configured such that the plurality of beams of the beam grids are configured to simultaneously scan the sample. In this way a total of up to twenty-one (21) beam areas may be provided over the same sample simultaneously.

In an arrangement up to seven (7) of the charged particle devices 41 with the arrangement of multiple-beam areas shown in and described with reference to **FIG. 9B** may be disposed facing a single sample having a diameter of 300 mm; desirably the charged particle device 41 is configured such that the plurality of beams of the beam grids are configured to simultaneously scan the sample. In this way a total of up to twenty-eight (28) beam areas may be provided over the same sample simultaneously. Up to seven (7) of the charged particle devices 41 with the beam area arrangement shown in **FIG. 9B** may be disposed facing a single sample having a diameter of 300 mm; desirably the charged particle device 41 is configured such that the plurality of beams of the beam grids are configured to simultaneously scan the sample. In this way a total of up to 42 beam areas may be provided over the same sample simultaneously.

Similar arrangements may be applied to the multi-device 41 shown in and described with reference to **FIGs 9C** **and** **10****.**

The element 300, 300', and any corresponding adjoining element (or facing adjoining element), be comprised in a lens array. The lens array may be a condenser lens array, which may correspond to the array of condenser lenses 231 as described above for example in reference to **FIG. 3****.** The charged particle device 41 may comprise a plurality of condenser lens arrays, each comprising an element 300' as described above in reference to **FIG. 9** and **FIG. 10****.** The one or more condenser lens arrays are desirably configured to generate the plurality of beams of the beam grid from the individual source beams. Alternatively, or additionally, the lens array may be an objective lens array, which may correspond to the objective lens array 241 as described above for example in reference to **FIG. 3****.** The charged particle device 41 may comprise a plurality of objective lens arrays, each comprising an element 300' as described above in reference to **FIG. 9** and **FIG. 10****.** The one or more objective lens arrays are desirably configured to operate on the plurality of beams of the beam grids.

An arrangement may comprise one or more condenser lens arrays and one or more objective lens arrays. Each of the lens arrays may comprise an element 300'. Such objective lens arrays are desirably disposed downbeam of the condenser lens arrays. In this way, the one or more condenser lens arrays are disposed at an upbeam position relative to the one or more objective lens arrays. The one or more objective lens arrays are disposed at a downbeam position relative to the one or more condenser lens arrays.

At least one of the one or more condenser lens arrays desirably has more than one of the plurality of beam areas. For example, the charged particle device 41 may comprise a single condenser lens array. As such a plurality of beam grids may form beam areas on the same condenser lens array. In an alternative arrangement, there may be a plurality of condenser lens arrays, for example each comprising a different element 300', and each condenser lens array may be disposed such that a plurality of beam areas correspond to each condenser lens array.

Similarly to the one or more condenser lens arrays, the charged particle device 41 (or multi-device 41) may additionally or alternatively comprise one or more objective lens arrays. At least one of the one or more objective lens arrays desirably has more than one of the plurality of beam areas. For example, the charged particle device 41 may comprise a single objective lens array. As such a plurality of beam grids may form beam areas on the same objective lens array. In an alternative arrangement, there may be a plurality of objective lens arrays and each objective lens array may be disposed such that a plurality of beam areas correspond to each objective lens array.

The one or more lens arrays optionally comprises a greater number of condenser lens arrays than objective lens arrays. Desirably, on average there are more beam areas per objective lens array than there are beam areas per condenser lens array. For example, there may be a plurality of condenser lens arrays and there may be a single objective lens array. The number of condenser lens arrays may optionally correspond to the number of sources. Alternatively, there may be the same number of beam areas per objective lens array as there are beam areas per condenser lens array. With this arrangement, desirably each objective lens array has the same number of beam areas as a corresponding condenser lens array assigned to the same source beam. For example, each objective lens array may be disposed directly downbeam of a corresponding condenser lens array.

In at least one of the one or more lens arrays, the aperture array define at least one pattern. The pattern may be present as a patterned array, such as a two dimensional array of apertures, in one or more of the elements 300' comprised in the one or more lens arrays. The pattern of apertures may have the apertures positioned over at least the beam areas provided by the one or more elements. For example, in at least one of the lens arrays the aperture array may define a single continuous pattern, for example a continuous pattern of a two dimensional array of apertures. In particular, in at least one of the one or more lens arrays the distance between apertures of the aperture array within two different, adjacent, beam areas may be the same as the distance between adjacent apertures of the two different beam areas. In this way, there may be no discontinuity of the pattern between different beam areas of the lens array; that is the pattern of apertures defining the beam areas may be continuous for example between and including the beam areas.

Alternatively, there may be a plurality of patterns. The plurality of patterns may be a plurality of occurrences of the same pattern. Alternatively, the plurality of patterns may comprise two or more distinct patterns which are different from each other. The plurality of patterns may be discontinuous with each other, such that a distance between adjacent apertures within in the same pattern is less than a distance between apertures of adjacent patterns. Each of the plurality of patterns may correspond to a respective beam area. For example, in at least one of the one or more lens arrays the distance between adjacent apertures from different, adjacent beams areas may be different from the distance between apertures in the respective beam areas. In particular, in at least one of the one or more lens arrays the distance between apertures of the aperture array within two different, adjacent, beam areas may different to the distance between adjacent apertures of the two different beam areas. Alternatively, the patterns may be distinct due to a difference in the arrangement of the apertures, instead of or in addition to, the patterns being distinct due to being distant from each other. Desirably, the aperture arrays of the one or more condenser lens arrays comprises more beam areas arrays of discontinuous patterns than the number of discontinuous patterns of aperture arrays of the objective lens array.

The one or more lens arrays desirably comprises a plurality of lens arrays including at least two groups of lens arrays. Each group of lens arrays comprises one or more lens arrays of the plurality of lens arrays. For example, the plurality of lens arrays may comprise a one or more condenser lens arrays, and the one or more condenser lens arrays may form one group of lens arrays. The plurality of lens arrays may comprise a one or more objective lens arrays, and the one or more objective lens arrays may form another group of lens arrays. The same may apply to collimating lens arrays and/or control lens arrays.

Desirably each group of lens arrays is configured to be individually controlled. In particular, at least one group of lens arrays may be configured to be actuated relative to at least another group of lens arrays of in at least one degree of freedom. Desirably the at least one of the one or more lens arrays is configured to be actuated in up to six degrees of freedom. This would desirably enables the groups of lens arrays to be aligned relative to each other.

The at least one group of lens arrays comprises at least one lens array having a plurality of beam areas. The plurality of beam areas optionally corresponding to one ring of beam areas, for example the inner ring 72 of the arrangement of **FIG. 10****.** Another group of lens may comprise at least one lens array having a plurality of beam areas corresponding to another ring of beam areas, for example the outer ring 73 of the arrangement of **FIG. 10****.** In this way, it may be possible to independently align the different lens arrays corresponding to the different rings of beam areas. In this way actuators configured to actuate the lens arrays may be shared among a group of lens arrays. Alternatively, each lens array may be provided with its own actuator such that each lens array is individually controllable, however this arrangement may be more complex and require a larger access area compared to an arrangement wherein only each group of lens arrays has a corresponding actuator, for example a single actuator.

As described above in reference to **FIG. 9** and **FIG. 10****,** an element 300' for example comprising a spacer and/or lens array of the charged particle device 41 (or multi-device) may be shared among a plurality of sources 201 instead of each source 201 being associated with dedicated elements 300' such as spacers and/or lens arrays which only interact with beam grids of the corresponding source 201. That is some if not all the sources may share a multi-device 41. Such elements may be shared between one or more of the plurality of sub-devices 42 of the multi-device 41; each source 201 may be associated with a different sub-device 42. Furthermore, in addition to, or instead of, elements 300', spacers and/or lens arrays being shared between a plurality of sources of a charged particle device, other components of the multi-device 41 may be shared.

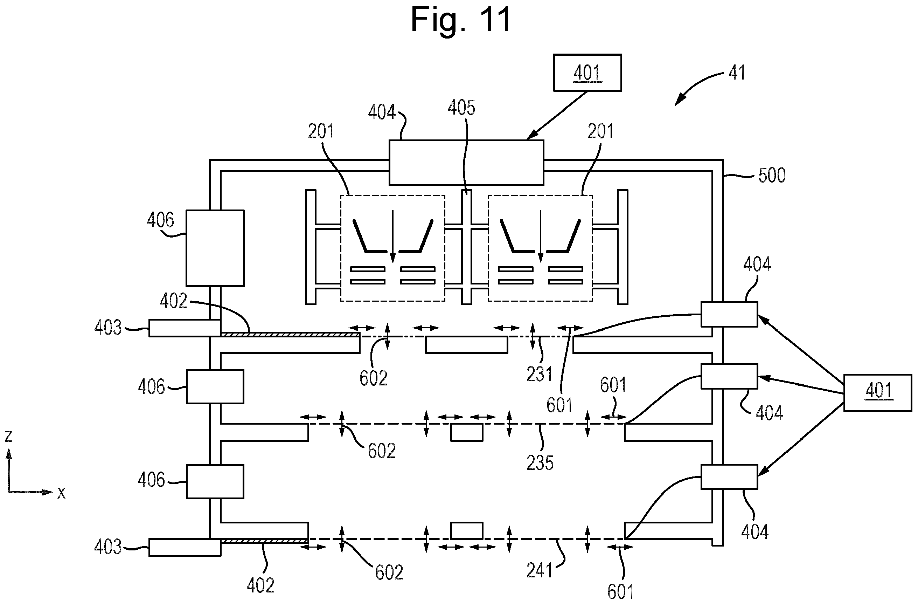

**FIG. 11** provides a side view (such as cross-section in the direction of a beam path or the electron-optical axis) of a charged particle apparatus including a charged particle device 41 (or multi-device 41). As an exemplary arrangement, the charged particle device 41 of **FIG. 11** provides an arrangement of four beam areas arranged in two rows of two beam areas, similar to the arrangement of beam areas depicted in **FIG. 9B****.** The charged particle device 41 of **FIG.11** comprises a plurality of charged particle beam sources 201. The charged particle device 41 of **FIG. 11** comprises four sources 201 (two of which are visible), a collimator 235, a condenser lens array 231, and an objective lens array 241. The collimator is configured to collimate the beams of the beam grid, for example as collimated beams towards the sample, from a diverging array of beams from the condenser lens array 231. As described above, in reference to **FIG. 8-10****,** the objective lens array 231 and/or the objective lens array 241 may be formed of one or more elements 300'. Further the detector 240 (which may be associated with the depicted objective lens array 241), the collimator array 235, control lens array (which may be associated with the objective lens array, the scan deflector array 235, and any other elements such as a corrector array, may each respectively comprise one or more elements 300'.

As shown by arrows 601, 602 in **FIG. 11****,** one or more of the collimator 235, condenser lens array 231, and objective lens array 241 may be actuated in one or more directions. In principle any of the elements or a charged particle device comprising a plurality of elements 300, 300' may be actuated in one or more directions. For example, one or more of the collimator 235, condenser lens array 231, and objective lens array 241 may be actuated in one or more translational directions and/or one or more rotational directions. In particular, one or more of the collimator 235, condenser lens array 231, and objective lens array 241 may be actuated in the Z-direction 602 of **FIG. 11****,** where the Z-direction may correspond to a direction of flow of charged particles from the source 201 to the sample, which may be a vertical direction. Additionally, or alternatively, one or more of the collimator 235, condenser lens array 231, and objective lens array 241 may be actuated in the X-direction 601 of **FIG. 11****,** where the X-direction may a lateral direction, orthogonal to the Z-direction, which may be a horizontal direction. Additionally, or alternatively, one or more of the collimator 235, condenser lens array 231, and objective lens array 241 may be actuated in the Y-direction which is a lateral, possibly horizontal, direction orthogonal to the X-direction and the Z-direction. The different electron-optical devices may be actuated to be rotated about any of the different axial directions of the frame of reference, for example around the X, Y and/or Z directions.

Furthermore, the one or more elements 300' may form the collimator 235. The collimator 235 is desirably configured to operate on beams associated with different beam areas and/or beam grids. In other words, the collimator 235 may be positioned such that the collimator 235 is in a path of beam grids from a plurality of sources 201. Similarly, the element 300' and/or the adjoining element may comprise a detector array, such that the element associated with the detector array has a plurality of beam areas. The detector array desirably comprises a detector element associated with each aperture. The detector array is desirably configured such that the detector elements are positioned to be associated for example proximate to the objective lens array. In an embodiment the detector array is desirably configured such that the detector elements are positioned to face a sample position at which a sample is place during use.

The charged particle device of **FIG. 11** further comprises a cooling conduits 402 configured to thermally condition the lens arrays. The cooling conduit may be a path or conduit for coolant such as a fluid such as water which may be thermally regulated to have a stable temperature. The coolant may have a high heat capacity enabling efficient thermal conditioning. In alternative arrangements, one or more cooling conduits may be provided to thermally condition any elements and/or the adjoining elements in the charged particle device. With such an arrangement, the cooling conduit is desirably in contact with the element and/or adjoining element. For example, the cooling conduit may be provided along a surface of the element for example remote from a beam area the element and/or adjoining element may consist of a material with a high heat capacity. Desirably the cooling conduit comprises at least one path between different beam areas.

The charged particle device 41 may be provided within a vacuum chamber. The charged particle device and vacuum chamber may form components of a charged particle apparatus. In particular, the charged particle device, such as the multi-device 41, is desirably housed entirely within the vacuum chamber. In this way, a plurality of sub-devices 42 may be disposed within the same common vacuum chamber, for example a wall 500 that may be contiguous, for example encasing the charged particle device 41 for maintaining the under pressure within the vacuum chamber. In an arrangement the vacuum chamber may comprise the actuated stage and optionally the support 209 for supporting a sample 208). A vacuum system comprising vacuum pumps may be used to maintain a vacuum inside the vacuum chamber. Vacuum ports 406 may be provided through the wall 500 of the vacuum chamber. The vacuum ports may be connected to the vacuum pumps of the vacuum system.

This may be a simpler and more efficient arrangement than alternative arrangement wherein each device has a dedicated single source and vacuum chamber. The common, or shared, vacuum chamber optionally comprises at least one cooling port 403, for example as shown in **FIG. 11****.** Although three are depicted, there can be as many or as few as required e.g., one. The apparatus may comprise a plurality of vacuum sub-chambers, desirably wherein each source 201 is housed within a respective vacuum sub-chamber. Cooling ports may be shared among the different sub-chambers such that the sub-chambers may be cooled efficiently and the device does not become overly complex. The cooling port 403 may be a feedthrough through the wall of the vacuum chamber for passage of the cooling conduit 402, or a fluid supply to the cooling conduit within the chamber, without low risk to the integrity of the vacuum chamber.

As shown for example in **FIG. 11****,** the charged particle device 41 may further comprise shielding 405 configured to extend at least partly between the paths of different beam grids. As shown in **FIG. 11****,** shielding 405 may be disposed between the paths of two or more beam grids such that the beam paths of two or more beam grids share shielding 405. In this way, there is efficient use of shielding within the device among the different beam grids associated with corresponding sources 201. In an alternative arrangement, the shielding may extend along the grid paths where the beam areas have discontinuous patterns.

As shown for example in **FIG. 11****,** the sources 201 comprising emitters, the apparatus further comprising shielding 405 at least between the emitters of the difference sources, for example between the different sources 201.

In the charged particle device 41 described above with reference to **FIG. 8-11****,** a voltage supply 401 may be configured to apply potential to the element and/or to the adjoining element. The applied potential may be at any potential within the operating range of the charged particle multi-device. For example the voltage supply may connect an element to ground. Desirably the voltage supply applies a potential to the different sources, for example at a potential for example ground or highly elevated potential different relative to the sample.. As shown in **FIG. 11****,** the voltage may be supplied by a voltage supply 401 to the sources 201 so as to emit charged particles for generating the different grids of beams for operation on by the different beam areas of the elements.

The voltage supply may apply a potential difference between the element and the adjoining element. In this way, a potential difference may be applied between to the adjacent beam areas of different elements, for example the element and the adjoining element, to supply a voltage of elevated potential to one or more elements of the device 41. The voltage supply 401 may apply potentials to one more elements of the lens array such as the condenser lens array 231 and/or an objective lens array 241. The voltage supply 401 may be provided to operate on such an element associated with a plurality of beam areas

The charged particle apparatus may comprise electronics associated with the element and/or adjoining element. Each element, and/or adjoining element, and its corresponding electronics, are desirably associated with two or more beam areas. For example, the element and/or further element may comprise an electrode array configured to be controlled by the electronics. In an arrangement in which at least one of the elements and adjoining element are a detector, the electronics may additionally have the function of receiving, processing and/or transmitting directional signals from the detector to an external process of the charged particle apparatus or assessment system. All or part of the electronics is optionally disposed at a position remote from the element and/or adjoining element. For example, the electronics may be disposed outside the vacuum chamber. Alternatively, or additionally, all or part of the electronics may be comprised on or adjacent the element and/or adjoining element.

In the chamber wall there may be one or more feedthroughs that enable services such as power such as electricity, signals (optical and/or electronic), and coolant through the chamber wall whilst maintaining vacuum within the vacuum chamber, The charged particle apparatus may further comprises such a feedthrough 404 configured for passage of an electrical connection of the voltage supply 401 to apply a potential such as an elevated potential to one or more elements of the device 41. Thus, there is a more efficient use of feedthroughs than in alternative arrangements wherein a different feedthrough is associated with a single beam area of a different element 300' of a corresponding single source.

Similarly, the charged particle apparatus may further comprise a feedthrough 404 configured to transmit, control signals to and receive detection signals from the device 41 for example the feedthrough 404 may be configured for passage of signal conductor to transmit in and out of the vacuum chamber for example with one more elements of the charged particle multi-device 41. The feedthrough 404 may be the same that as used to supply voltage or may be a different, additional feedthrough. Feedthrough 404 (which may be one feedthrough for all sources, or one or more feedthroughs each for a different source or group of sources) may be configured for passage of an electrical connection from the voltage supply 401 to the sources 201, such as the emitters.

The same feedthrough 404 may be used for passage of control signals, detection signals and/or electrical supply, for example to set potentials of the sources and/or an element, through the wall 500 of the vacuum chamber. Thus one or more of the cooling ports 403 through the vacuum chamber wall 500 is, in effect, a feedthrough. In an arrangement the cooling conduit 402 is comprised within the same feedthrough 404, 403, for control signals, detections and/or electrical supply. Although having individual feedthroughs for different functions may aid layout within the vacuum chamber and help to simplify the layout of services lines (e.g., cables fibers and tubes) within the chamber which may help in maintaining the vacuum chamber to a desirably small size, it may be preferable to pool (or combine) functions into a low number of feedthroughs, preferably one, A fewer number of feedthroughs may help to reducing the risk of vacuum breakdown. A feedthrough suitable for such combined function for services lines (e.g., of cables, wires, pipes and other features for transmitting electrical signals such as a PCB) is shown in and described in WO2018121969 which claiming a priority date of 27 December 2016 and is hereby incorporated by reference at least so far as the features of the feedthrough and the manner in which feeds through service lines.

There are provided the following clauses:
Clause 1. A charged particle device for projecting a multi-beam of charged particles towards a sample, the device comprising: a plurality of sources configured to emit a respective source beam of charged particles along a respective path of a beam grid towards the sample, the beam grid comprising a plurality of charged particle beams; one or more elements, in which an array of apertures is defined respectively comprising a plurality of beam areas assigned to an individual source beam, wherein the one or more elements is configured to operate on the charged particle beams in the beam grids of the individual source beam; wherein each element is separated from an adjoining element by a spacer, the spacer having at least one aperture positioned to correspond to the position of at least two beam areas.
Clause 2. The device of clause 1, wherein the one or more elements is configured to be positioned such that the array of apertures is disposed along the path of the beam grid.
Clause 3. The device of clause 1 or 2, wherein each beam area corresponds to an individual beam grid of one of the individual source beams.
Clause 4. The device of any preceding clause, wherein the element is an electrode of a lens array, desirably wherein the electrode is an electrode plate, desirably wherein the lens array comprises the adjoining element and the spacer.
Clause 5. The device of any preceding clause, wherein the spacer comprises an outer support disposed between the adjoining elements for supporting the adjoining elements.
Clause 6. The device of clause 5, wherein the outer support defines the at least one aperture, desirably wherein the aperture is positioned to correspond to the position of the plurality of beam areas, desirably wherein the outer support is positioned to surround the plurality of beam areas.
Clause 7. The device of any preceding clause, wherein the plurality of beam areas are arranged in a two dimensional array desirably having a pattern, the two dimensional array desirably comprising at least 2 parallel rows of beam areas, wherein each row comprises at least 2 beam areas.
Clause 8. The device of clause 7, wherein the plurality of beam areas comprises at least one ring of beam areas arranged in a two dimensional ring around a central position at a midpoint of the plurality of beam areas, desirably the at least one ring of beam areas comprises up to 4 rings of beam areas.
Clause 9. The device of clause 7, wherein the two dimensional array comprises beam areas arranged around a mid-region, desirably the mid-region being at a central position, of the plurality of beam areas, desirably the two dimensional array is annular, such as an annulus of beam areas, desirably the annulus forming at least one ring.
Clause 10. The device of clause 8 or 9, wherein the at least one ring of beam areas comprises an inner ring of beam areas arranged adjacent to the central position, desirably wherein the inner ring of beam areas comprises up to 6 beam areas.
Clause 11. The device of clause 10, wherein the at least one ring of beam areas comprises an outer ring of beam areas, wherein the outer ring of beam areas surrounds the inner ring of beam areas, desirably wherein the outer ring of beam areas is positioned concentrically around the inner ring of beam areas, desirably wherein the outer ring of beam areas comprises of up to 20 beam areas.
Clause 12. The device of any proceeding clause, wherein the spacer comprises an intermediate support disposed between the adjoining elements for supporting the adjoining elements, wherein the intermediate support is positioned between two adjoining beam areas, for example equidistant between two or more beam areas, desirably the position of the intermediate support corresponds to the mid-region, desirably the intermediate support surrounds one or more of the beam areas, for example and is positioned around the mid-region, for example in the spacer is defined a plurality of the apertures and the intermediate support may define one or more of the apertures through the support.
Clause 13. The device of clause 11, wherein the spacer comprises an intermediate support disposed between the adjoining elements for supporting the adjoining elements, wherein the intermediate support is positioned between, at least one beam area of the inner ring of beam areas and at least one beam area of the outer ring of beam areas, desirably wherein the intermediate support surrounds the inner ring of beam areas and the intermediate support is surrounded by the outer ring of beam areas, desirably wherein the intermediate support defines one of the at least one apertures and the intermediate support is positioned to correspond to the inner ring of beam areas.
Clause 14. The device of any of clauses 8 to 13, wherein the plurality of beam areas comprises a central beam area positioned in the mid-region, desirably at the central position.
Clause 15. The device of any preceding clause, wherein the spacer comprises an inner support disposed between the adjoining elements for supporting the adjoining elements, wherein a periphery of the inner support is surrounded by more than two of the beam areas, desirably wherein the inner support is positioned at a central position at a midpoint of the plurality of beam areas.
Clause 16. The device of any of clauses 4 to 15, wherein the one or more lens arrays comprises one or more condenser lens arrays.
Clause 17. The device of clause 11, wherein the one or more condenser lens arrays are configured to generate the plurality of beams of the beam grid from the individual source beams.
Clause 18. The device of any of clauses 4 to 15, wherein the one or more lens arrays comprises one or more objective lens arrays configured to operate on the plurality of beams of the beam grids.
Clause 19. The device of clause 16 or 17, wherein the one or more lens arrays comprises one or more objective lens arrays configured to operate on the plurality of beams of the beam grids.
Clause 20. The device of clause 18 or 19, wherein the one of the objective lens arrays has more than one of the plurality of beam areas.
Clause 21. The device of clause 19 or 20, wherein the one or more lens arrays comprises a greater number of condenser lens arrays than objective lens arrays, desirably wherein the aperture arrays of the condenser lens array comprises more discontinuous patterns than of the objective lens array.
Clause 22. The device of any of clauses 19 to 21, wherein on average there are more beam areas per objective lens array than there are beam areas per condenser lens array.
Clause 23. The device of clause 19 or 20, wherein there are the same number of beam areas per objective lens array as there are beam areas per condenser lens array, desirably wherein each objective lens array has the same number of beam areas as a corresponding condenser lens array assigned to the same source beam.
Clause 24. The device of any of clauses 16 to 23, wherein in at least one of the one or more lens arrays the patterns of the aperture arrays of different beam areas in the array are the same.
Clause 25. The device of any of clauses 16 to 24, wherein in at least one of the one or more lens arrays the distance between adjacent apertures of a beam area is the same.
Clause 26. The device of any of clauses 16 to 25, wherein in at least one of the one or more lens arrays the distance between adjacent apertures from different, adjacent beams areas is different from the distance between apertures in the respective beam areas.
Clause 27. The device of any of clauses 16 to 26, wherein at least one of the one or more lens arrays comprises the apertures of the different beam areas having a discontinuous pattern between the different beam areas.
Clause 28. The device of any of clauses 16 to 27, wherein in at least one of the one or more lens arrays the distance between apertures within two different, adjacent, beam areas is the same as the distance between adjacent apertures of the two different beam areas, wherein the apertures of the different beam areas have a continuous pattern.
Clause 29. The device of any of the preceding clauses, wherein the one or more lens arrays comprises a plurality of lens arrays including at least two groups of lens arrays wherein each group of lens arrays comprises one or more lens arrays of the plurality of lens arrays; and wherein each group of lens arrays is configured to be individually controlled.
Clause 30. The device of clause 29, wherein at least one group of lens arrays is configured to be actuated relative to at least another group of lens arrays of in at least one degree of freedom, desirably wherein the at least one of the one or more lens arrays is configured to be actuated in up to six degrees of freedom.
Clause 31. The device of clause 30, wherein at least one of the groups of lens arrays comprises a plurality of lens arrays, desirably wherein the at least one of the groups of lens arrays comprises lens arrays having a plurality of beam areas corresponding to a ring of beam areas.
Clause 32. The device of clause 29 or 30, wherein the at least two groups of lens arrays comprises at least one group of condenser lens arrays and at least one group of objective lens arrays, desirably wherein the number of groups of condenser lens arrays is different than the number of groups of objective lens arrays.
Clause 33. The device of any of the preceding clauses, wherein a voltage is configured to be applied to the aperture array and/or to the adjoining element so as to supply the different beam areas with the voltage.
Clause 34. The device of clause 33, further comprising a voltage supply configured to supply the voltage.
Clause 35. The device of any preceding clause, wherein the element or the adjoining element comprises a detector array desirably comprising an detector element associated with each aperture, desirably the detector is configured to face a sample position.
Clause 36. The device of any proceeding clause, further comprising a cooling conduit configured to thermally condition the element and/or the adjoining element, desirably the cooling conduit is in contact with the element and/or adjoining element, for example along a surface of the element, desirably the cooling conduit comprising a path between different beam areas desirably with a discontinuous pattern.
Clause 37. The device of any proceeding clause, wherein associated with the element and/or adjoining element is electronics associated with two or more beam areas, desirably the element and/or further element comprises an electrode array configured to be controlled by the electronics, for example the electronics may be remote from the element and/or adjoining element and/or may be comprised on the element and/or adjoining element.
Clause 38. The device of any proceeding clauses, wherein the plurality of elements comprises a collimator configured to collimate the beams of the beam grid, desirably from a diverging path, desirably the collimators operating on beams associated with different beam areas and/or beam grids.
Clause 39. The device of any preceding clause, further comprising shielding, wherein the shielding is configured to extend at least partly between the paths of different beam grids for example along the grid paths where the beam areas have discontinuous patterns, desirably so that along part of the paths of the beam grids, the beam paths share shielding.
Clause 40. The device of any preceding clause, the sources comprising emitters, the apparatus further comprising shielding between the emitters.
Clause 41. A charged particle apparatus for projecting a multi-beam of charged particles towards a sample, the apparatus comprising the device of any of the preceding clauses and a stage configured to support a sample.
Clause 42. The apparatus of clause 41, further comprising a vacuum chamber, wherein the device is housed within the vacuum chamber, desirably wherein the vacuum chamber comprises at least one cooling port.
Clause 43. The apparatus of clause 42, further comprising a plurality of vacuum sub-chambers, desirably wherein each source is housed within a respective vacuum sub-chamber.
Clause 44. The apparatus of any of clauses 41 to 43, further comprising a feedthrough configured to supply a voltage of elevated potential to one or more elements of the device, desirably the feedthrough for supplying a voltage applied to one or more elements of the device, such elements operating on two or more of the beam areas.
Clause 45. The apparatus of any of clauses 41 to 44, further comprising a feedthrough configured to transmit control signals to and receive detection signals from the device, desirably one or more elements of the device, such elements operating on two or more of the beam areas.

Reference to a component or system of components or elements being controllable to manipulate a charged particle beam in a certain manner includes configuring a controller or control system or control unit to control the component to manipulate the charged particle beam in the manner described, as well optionally using other controllers or devices (e.g. voltage supplies and or current supplies) to control the component to manipulate the charged particle beam in this manner. For example, a voltage supply may be electrically connected to one or more components, such as the elements 300' of the respective component, to apply potentials to the components, such as in a non-limited list the control lens array 250, the objective lens array 241, the condenser lens 231, correctors, a collimator element array and scan deflector array 260, under the control of the controller or control system or control unit. An actuatable component, such as a stage, may be controllable to actuate and thus move relative to another components such as the beam path using one or more controllers, control systems, or control units to control the actuation of the component.

The embodiments herein described may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a sub-beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). For example, the aperture arrays, plate electrodes of for example the objective lens array, one more features of the detector array, scan-deflector array and collimator element array, may be formed using MEMS manufacturing techniques.

References to upper and lower, up and down, above and below should be understood as referring to directions parallel to the (typically but not always vertical) upbeam and downbeam directions of the electron beam or multi-beam impinging on the sample 208. Thus, references to upbeam and downbeam are intended to refer to directions in respect of the beam path independently of any present gravitational field. These references are intended to correspond with the general direction of the electron beam from source to sample. However these references with respect to the beam path may correspond to references with respect to the electron-optical axis of device 41. For a multi-device 41, the direction of the beam path least one of the sub-devices 42 (a reference sub-device) may correspond to the electron-optical axis of the same sub-device 41. The other sub-devices of the multi-device 41 may be calibrated with respect to the reference sub-device. The electron-optical axis may correspond to a geometrical axis of the reference sub-device and, in an embodiment, of the multi-device,

An assessment system according to an embodiment of the disclosure may be a tool which makes a qualitative assessment of a sample (e.g. pass/fail), one which makes a quantitative measurement (e.g. the size of a feature) of a sample or one which generates an image of map of a sample. Examples of assessment systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The electron-optical device 41 may be a component of a charged particle assessment system 40; such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

The terms "sub-beam" and "beamlet" are used interchangeably herein and are both understood to encompass any radiation beam derived from a parent radiation beam by dividing or splitting the parent radiation beam. The term "beam" may be used synonymously with "sub-beam" and "beamlet". The term "manipulator" is used to encompass any element which affects the path of a sub-beam or beamlet, such as a lens or deflector.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

## Claims

1. A charged particle device for projecting a multi-beam of charged particles towards a sample, the device comprising:
a plurality of sources configured to emit a respective source beam of charged particles along a respective path of a beam grid towards the sample, the beam grid comprising a plurality of charged particle beams;
one or more elements, in which an array of apertures is defined respectively comprising a plurality of beam areas assigned to an individual source beam, wherein the one or more elements is configured to operate on the charged particle beams in the beam grids of the individual source beam;
wherein each element is separated from an adjoining element by a spacer, the spacer having at least one aperture positioned to correspond to the position of at least two beam areas.

2. The device of claim 1, wherein the one or more elements is configured to be positioned such that the array of apertures is disposed along the path of the beam grid.

3. The device of claim 1 or 2, wherein each beam area corresponds to an individual beam grid of one of the individual source beams.

4. The device of any preceding claim, wherein the element is an electrode of a lens array, desirably wherein the electrode is an electrode plate, desirably wherein the lens array comprises the adjoining element and the spacer.

5. The device of any preceding claim, wherein the spacer comprises an outer support disposed between the adjoining elements for supporting the adjoining elements.

6. The device of claim 5, wherein the outer support defines the at least one aperture, desirably wherein the aperture is positioned to correspond to the position of the plurality of beam areas, desirably wherein the outer support is positioned to surround the plurality of beam areas.

7. The device of any preceding claim, wherein the plurality of beam areas are arranged in a two dimensional array desirably having a pattern, the two dimensional array desirably comprising at least 2 parallel rows of beam areas, wherein each row comprises at least 2 beam areas.

8. The device of claim 7, wherein the plurality of beam areas comprises at least one ring of beam areas arranged in a two dimensional ring around a central position at a midpoint of the plurality of beam areas, desirably the at least one ring of beam areas comprises up to 4 rings of beam areas.

9. The device of claim 7, wherein the two dimensional array comprises beam areas arranged around a mid-region, desirably the mid-region being at a central position, of the plurality of beam areas, desirably the two dimensional array is annular, such as an annulus of beam areas, desirably the annulus forming at least one ring.

10. The device of claim 8 or 9, wherein the at least one ring of beam areas comprises an inner ring of beam areas arranged adjacent to the central position, desirably wherein the inner ring of beam areas comprises up to 6 beam areas.

11. The device of claim 10, wherein the at least one ring of beam areas comprises an outer ring of beam areas, wherein the outer ring of beam areas surrounds the inner ring of beam areas, desirably wherein the outer ring of beam areas is positioned concentrically around the inner ring of beam areas, desirably wherein the outer ring of beam areas comprises of up to 20 beam areas.

12. The device of any proceeding claim, wherein the spacer comprises an intermediate support disposed between the adjoining elements for supporting the adjoining elements, wherein the intermediate support is positioned between two adjoining beam areas, for example equidistant between two or more beam areas, desirably the position of the intermediate support corresponds to the mid-region, desirably the intermediate support surrounds one or more of the beam areas, for example and is positioned around the mid-region, for example in the spacer is defined a plurality of the apertures and the intermediate support may define one or more of the apertures through the support.

13. The device of any preceding claim, wherein the spacer comprises an inner support disposed between the adjoining elements for supporting the adjoining elements, wherein a periphery of the inner support is surrounded by more than two of the beam areas, desirably wherein the inner support is positioned at a central position at a midpoint of the plurality of beam areas.

14. The device of any of claims 4 to 13, wherein the one or more lens arrays comprises one or more condenser lens arrays and/or wherein the one or more lens arrays comprises one or more objective lens arrays configured to operate on the plurality of beams of the beam grids.

15. The device of claim 14, wherein the one or more lens arrays comprises a greater number of condenser lens arrays than objective lens arrays, desirably wherein the aperture arrays of the condenser lens array comprises more discontinuous patterns than of the objective lens array.
